(19) Europäisches Patentamt / European Patent Office / Office européen des brevets

(11) **EP 4 783 465 A1**

(12) **EUROPEAN PATENT APPLICATION**
published in accordance with Art. 153(4) EPC

(43) Date of publication:
**29.07.2026 Bulletin 2026/31**

(21) Application number: **23957618.4**

(22) Date of filing: **31.10.2023**

(51) International Patent Classification (IPC):
**H03M 7/30** (2006.01)     **H03M 7/46** (2006.01)

(52) Cooperative Patent Classification (CPC):
**H03M 7/30; H03M 7/46**

(86) International application number:
**PCT/JP2023/039338**

(87) International publication number:
**WO 2025/094290 (08.05.2025 Gazette 2025/19)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Mitsubishi Electric Corporation Tokyo 100-8310 (JP)**

(72) Inventor: **MORI, Ikumi Tokyo 100-8310 (JP)**

(74) Representative: **Pfenning, Meinig & Partner mbB Patent- und Rechtsanwälte An der Frauenkirche 20 01067 Dresden (DE)**

(54) **DATA COMPRESSION DEVICE, DATA COMPRESSION METHOD, AND DATA COMPRESSION PROGRAM**

(57)     A data compression device (100) which compresses discrete time-series data including a plurality of consecutive values consisting of time-series consecutive one or more data points indicating identical values includes a noise determination unit (11). Assuming that each consecutive value included in the time-series data is a target consecutive value, the noise determination unit (11) determines that the target consecutive value is noise if a duration of the target consecutive value is less than a designated period and a difference between a value of the target consecutive value and a value of a data point immediately preceding a start point in a time-series manner of the target consecutive value is less than or equal to a difference threshold, determines that the target consecutive value is not noise if the duration of the target consecutive value is equal to or greater than the designated period and the difference between the value of the target consecutive value and the value of the data point immediately preceding the start point in a time-series manner of the target consecutive value is less than or equal to the difference threshold, and generates compressed data being data that: does not indicate each consecutive value determined to be noise; indicates each consecutive value determined not to be noise; and is obtained by compressing the time-series data.

Fig.1

## Description

### Technical Field

The present disclosure relates to a data compression device, a data compression method, and a data compression program.

### Background Art

There is a technology to compress discrete time-series data that includes many consecutive values. Patent Literature 1 discloses an example of this technology.

### Citation List

### Patent Literature

Patent Literature 1: JP2001-165712 A

### Summary of Invention

### Technical Problem

According to the technology disclosed in Patent Literature 1, time-series data is compressed in accordance with a specific time period, that is, the time-series data is compressed without considering a length of period in which identical values continue. Also, in this technology, when a value change greater than a deadband width occurs, data corresponding to the change in value is saved. Accordingly, the technology has a problem that in a case where the value changes within a range of the deadband width in a specific time period, even if the change in value cannot be considered to be due to noise, the time-series data after compression does not sometimes include information indicating the change in value.

In this context, since a vast amount of data is used in the training process of machine learning, it is preferable to maximize the compression ratio of the data. In addition, a change point is regarded important in machine learning. Furthermore, even when training using noise-removed data is performed, impact on accuracy is generally minor. Therefore, in compressing discrete time-series data that includes many consecutive values for the purpose of generating data to be used in a training process of machine learning, it is preferable, while removing noise, even when a value changes within a range of a deadband width, to retain information indicating data in a period during which identical values continue, as long as the period during which the identical values continue is equal to or longer than a predetermined period.

In a technology for compressing discrete time-series data that includes many consecutive values, the present disclosure aims, while removing noise, even when a value changes within a range of a difference threshold, to retain information indicating data in a period during which identical values continue, as long as the period during which the identical values continue is equal to or longer than a designated period.

### Solution to Problem

A data compression device according to the present disclosure compresses discrete time-series data including a plurality of consecutive values consisting of time-series consecutive one or more data points indicating identical values, and

the data compression device includes a noise determination unit which,
assuming that each consecutive value included in the time-series data is a target consecutive value,
determines that the target consecutive value is noise if a duration of the target consecutive value is less than a designated period and a difference between a value of the target consecutive value and a value of a data point immediately preceding a start point in a time-series manner of the target consecutive value is less than or equal to a difference threshold,
determines that the target consecutive value is not noise if the duration of the target consecutive value is equal to or greater than the designated period and the difference between the value of the target consecutive value and the value of the data point immediately preceding the start point in a time-series manner of the target consecutive value is less than or equal to the difference threshold, and
generates compressed data being data that: does not indicate each consecutive value determined to be noise; indicates each consecutive value determined not to be noise; and is obtained by compressing the time-series data.

**Advantageous Effects of Invention**

According to the present disclosure, the noise determination unit determines that a target consecutive value is noise if a duration of the target consecutive value is less than a designated period and a difference between a value of the target consecutive value and a value of a data point immediately preceding a start point in a time-series manner of the target consecutive value is less than or equal to a difference threshold. The noise determination unit determines that the target consecutive value is not noise if the duration of the target consecutive value is equal to or greater than the designated period and a difference between the value of the target consecutive value and the value of the data point immediately preceding the start point in a time-series manner of the target consecutive value is less than or equal to the difference threshold. The noise determination unit generates compressed data being data that: does not indicate each consecutive value determined to be noise; indicates each consecutive value determined not to be noise; and is obtained by compressing the time-series data. The time-series data is discrete data including a plurality of consecutive values.

Therefore, according to the present disclosure, in a technology for compressing discrete time-series data that includes many consecutive values, it is preferable, while removing noise, even when a value changes within a range of a difference threshold, to retain information indicating data in a period during which the identical values continue, as long as a period during which identical values continue is equal to or longer than a designated period.

**Brief Description of Drawings**

Fig. 1 is a diagram illustrating a configuration example of a data compression system 90 according to Embodiment 1.
Fig. 2 is a diagram illustrating a configuration example of a data compression system 90 according to Embodiment 1.
Fig. 3 is a diagram describing processing of a noise determination unit 11 according to Embodiment 1.
Fig. 4 is a diagram describing the processing of the noise determination unit 11 according to Embodiment 1, where (a) describes a steady state and a transient state, and (b) describes a function corresponding to a performance of an air conditioner.
Fig. 5 describes processing of the noise determination unit 11 according to Embodiment 1.
Fig. 6 is a diagram illustrating a hardware configuration example of a data compression device 100 according to Embodiment 1.
Fig. 7 is a flowchart illustrating processing of the data compression system 90 according to Embodiment 1.
Fig. 8 is a flowchart illustrating processing of the noise determination unit 11 according to Embodiment 1.
Fig. 9 is a flowchart illustrating the processing of the noise determination unit 11 according to Embodiment 1.
Fig. 10 is a diagram illustrating a hardware configuration example of a data compression device 100 according to a modification of Embodiment 1.
Fig. 11 is a diagram illustrating a configuration example of a data compression system 90 according to Embodiment 2.
Fig. 12 is a diagram illustrating a configuration example of a statistic selection unit 30 according to Embodiment 2.
Fig. 13 is a diagram describing a designated period 12 and a difference threshold 13 according to Embodiment 2.
Fig. 14 is a flowchart illustrating processing of the data compression system 90 according to Embodiment 2.
Fig. 15 is a flowchart illustrating processing of the statistic selection unit 30 according to Embodiment 2.
Fig. 16 is a flowchart illustrating processing of a designated period calculation unit 32 according to Embodiment 2.
Fig. 17 is a flowchart illustrating processing of a difference threshold calculation unit 34 according to Embodiment 2.
Fig. 18 is a diagram illustrating a configuration example of a data compression system 90 according to Embodiment 3.
Fig. 19 is a diagram illustrating a configuration example of a parameter determination unit 40 according to Embodiment 3.
Fig. 20 is a diagram illustrating a configuration example of a statistic selection unit 30 according to Embodiment 3.
Fig. 21 is a diagram describing processing of the data compression system 90 according to Embodiment 3.
Fig. 22 is a flowchart illustrating the processing of the data compression system 90 according to Embodiment 3.
Fig. 23 is a flowchart illustrating the processing of the data compression system 90 according to Embodiment 3.
Fig. 24 is a flowchart illustrating processing of the statistic selection unit 30 according to Embodiment 3.
Fig. 25 is a flowchart illustrating processing of the parameter determination unit 40 according to Embodiment 3.
Fig. 26 is a flowchart illustrating the processing of the parameter determination unit 40 according to Embodiment 3.

**Description of Embodiments**

In the description and drawings of the embodiments, the same reference signs are attached to the same elements and equivalent elements. The description of the elements to which the same reference signs are attached may be omitted or simplified as appropriate. Arrows in diagrams mainly indicate flows of data or flows of processing. In addition, the word "unit" or "device" may be appropriately replaced with "system", "circuit", "stage", "procedure", "process" or "circuitry".

Embodiment 1.

Hereinafter, the present embodiment will be described in detail with reference to drawings.

In a technology that compresses discrete time-series data including many consecutive values, for the purpose of generating data to be used in a training process of machine learning, the present embodiment aims at enabling both of: reducing an amount of data by removing noise that has no or little impact on machine learning; and equalizing an accuracy of a machine learning model that executes training based on data with noise removed, with an accuracy of a machine learning model that was trained using raw data. Also, the present embodiment aims to reduce an amount of data by compressing time-series data through removing weak noise from the time-series data for the purpose of reducing storage costs of the time-series data. The time-series data related to the present embodiment is data composed of discrete values and including several consecutive values. In other words, the time-series data is discrete time-series data. The consecutive values consist of time-series consecutive one or more data points indicating the identical values.

As a specific example, in an IoT (Internet of Things) use case, a number of consecutive values increases. The reasons for this include a low sensor sensitivity (resolution), intentional rounding off of the values by, for example, counting fractions over half as one and disregarding the rest, and so on. Note that an isolated point is sometimes expressed as a consecutive value. The value of an isolated point differs from the value of any data point adjacent to the isolated point.

*** Description of Configuration ***

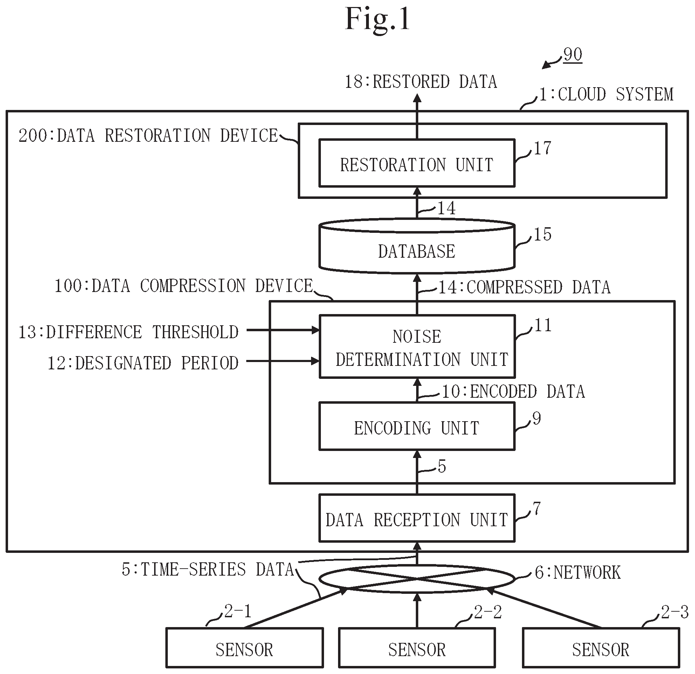

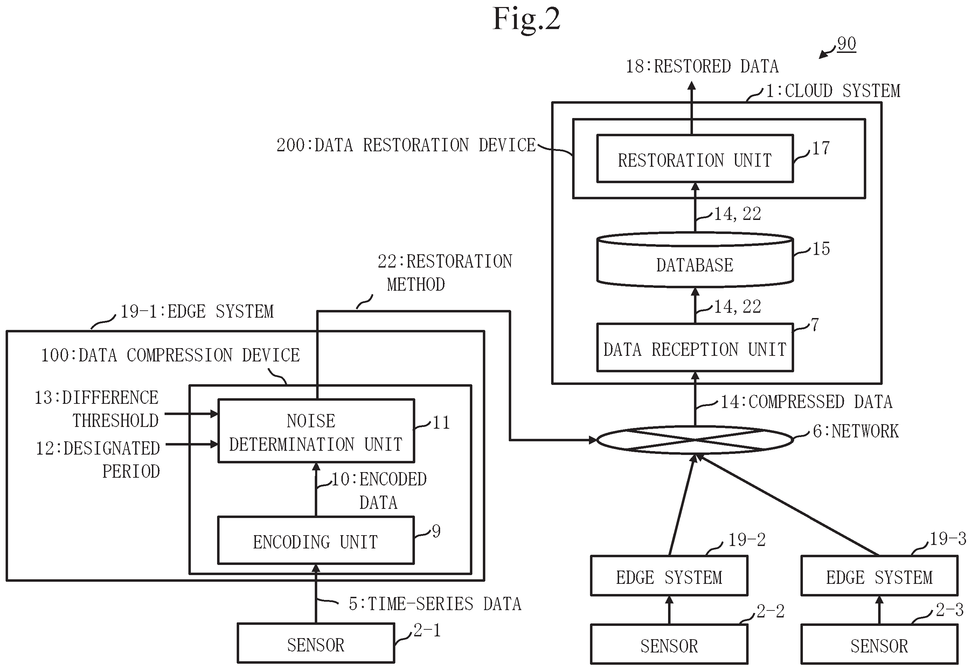

Fig. 1 and Fig. 2 illustrate configuration examples of a data compression system 90 according to the present embodiment.

A data compression device 100 compresses time-series data. The data compression device 100 may be implemented either by a cloud system 1 as shown in Fig. 1, or by edge systems 19 as shown in Fig. 2. The data compression device 100 and a data restoration device 200 may be configured integrally.

Hereafter, a specific example of implementing the data compression device 100 by the cloud system 1 will be described.

The case where the data compression device 100 is implemented by the edge system 19 is equivalent to the case where the data compression device 100 is implemented by the cloud system 1. A restoration method 22 is data that illustrates a method for restoring compressed data 14.

Time-series data 5 acquired by each sensor 2 is sent to the cloud system 1 via a network 6. The time-series data 5 is data formed by recording, in a time-series manner, sensor values acquired by the sensors 2. The time-series data 5 corresponds to the raw data.

The cloud system 1 is equipped with a data reception unit 7, the data compression device 100, a database 15, and the data restoration device 200.

The data reception unit 7 receives the time-series data 5.

The data compression device 100 includes an encoding unit 9 and a noise determination unit 11.

The encoding unit 9 receives the time-series data 5 from the data reception unit 7, and generates encoded data 10 by encoding the received time-series data 5.

As a specific example, the encoding unit 9 generates the encoded data 10 through differential encoding. Differential encoding is a method of compressing discrete time-series data based on a difference between adjacent data points. In differential encoding, each data point is retained if the difference from a data point immediately preceding in a time-series manner is not 0, and is deleted if the difference from the data point immediately preceding in a time-series manner is 0.

The noise determination unit 11 determines whether a partial data point series included in the encoded data 10 is noise or not based on a designated period 12 and a difference threshold 13, and generates the compressed data 14 by deleting from the encoded data 10 the partial data point series determined to be noise. The noise determination unit 11 may generate the compressed data 14 by differential encoding. The noise determination unit 11 saves the generated compressed data 14 to the database 15. The compressed data 14 is data that: does not indicate each consecutive value determined to be noise by the noise determination unit 11; indicates each consecutive value determined not to be noise by the noise determination unit 11; and is obtained by compressing the time-series data 5. The compressed data 14 may also be data obtained by further compressing the encoded data 10.

In the present embodiment, the designated period 12 and the difference threshold 13 are introduced to determine whether each data point is noise or not. The designated period 12 and the difference threshold 13 may be each a value calculated based on domain knowledge. In addition, the noise determination unit 11 may use the time-series data 5 in place of the encoded data 10. The compressed data 14 corresponds to data representing features extracted from the raw data.

The noise determination unit 11 determines that a certain consecutive value is noise when the duration of the consecutive value is shorter than the designated period 12. However, the noise determination unit 11 does not determine that a consecutive value is noise, even when the consecutive value is determined to be noise based on the designated period 12, if a difference (change) between a value of the consecutive value and a value of a data point immediately preceding the start point in a time-series manner of the consecutive value is greater than the difference threshold 13.

Assuming that each consecutive value included in the time-series data 5 is a target consecutive value, the noise determination unit 11 determines that the target consecutive value is noise if a duration of the target consecutive value is less than the designated period 12 and a difference between a value of the target consecutive value and a value of a data point immediately preceding a start point in a time-series manner of the target consecutive value is less than or equal to the difference threshold 13. Furthermore, the noise determination unit 11 determines that the target consecutive value is not noise if the duration of the target consecutive value is equal to or greater than the designated period 12 and the difference between the value of the target consecutive value and the value of the data point immediately preceding the start point in a time-series manner of the target consecutive value is less than or equal to the difference threshold 13. The noise determination unit 11 also determines that the target consecutive value is not noise if the difference between the value of the target consecutive value and the value of the data point immediately preceding the start point in a time-series manner of the target consecutive value is greater than the difference threshold 13.

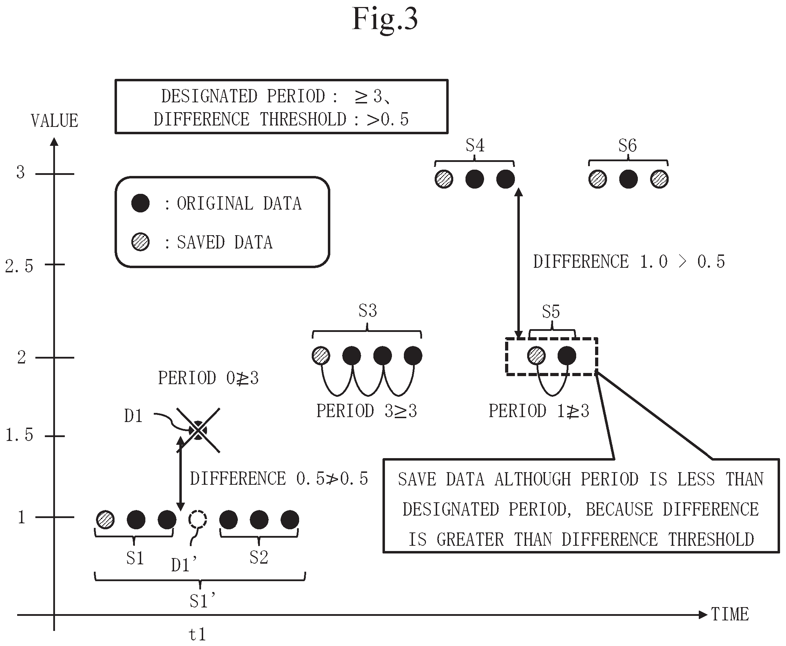

Fig. 3 is a diagram that describes a specific example of processing of the noise determination unit 11. In Fig. 3, the designated period 12 is 3, and the difference threshold 13 is 0.5. In Fig. 3, original data and saved data are illustrated. The original data is each data point indicated by the time-series data 5. The saved data is each data point, among the data points indicated by the time-series data 5, that is saved in the compressed data 14 and prescribed based on differential encoding.

A duration of data D1 is 0, that is, less than the designated period 12. Also, a difference between a value of the data D1 and a value of a consecutive value S1 is 0.5, that is, less than or equal to the difference threshold 13. Here, the value of the consecutive value S1 is a value of a data point immediately preceding the data D1 in a time-series manner. The data D1 is also a consecutive value. Therefore, the noise determination unit 11 determines the data D1 as noise and deletes the data D1 from the encoded data 10. It should be noted that in the example shown in Fig. 3, the values of the time-series data 5 and encoded data 10 at time t1 are 1.5, but the value of data restored from the compressed data 14 is 1 at time t1. That is, the data D1 is virtually treated as data D1' in the compressed data 14.

Here, the duration of each of the consecutive value S1 and a consecutive value S2 is 2. However, since the data D1 is treated as the data D1', the consecutive value S1, the data D1', and the consecutive value S2 are integrally treated as a consecutive value S1'. A duration of the consecutive value S1' is 6, that is, equal to or greater than the designated period 12, so the noise determination unit 11 does not determine the consecutive value S1' as noise. Note that the noise determination unit 11 may regard the consecutive value S1 and consecutive value S2 as a whole as consecutive data points.

A duration of a consecutive value S3 is 3, that is, equal to or greater than the designated period 12. Therefore, the noise determination unit 11 does not determine the consecutive value S3 as noise.

A duration of a consecutive value S4 is 2. However, a difference between a value of the consecutive value S4 and a value of the consecutive value S3 is larger than the difference threshold 13. Therefore, the noise determination unit 11 does not determine the consecutive value S4 as noise. Similarly, the noise determination unit 11 does not determine each of a consecutive value S5 and a consecutive value S6 as noise.

The database 15 is a database that stores the generated compressed data 14.

The data restoration device 200 includes a restoration unit 17.

The restoration unit 17 acquires the compressed data 14 from the database 15 and restores the acquired compressed data 14 into time-series data as a restored data 18. During this, the restoration unit 17 uses a decoding algorithm corresponding to an algorithm that encoded the compressed data 14.

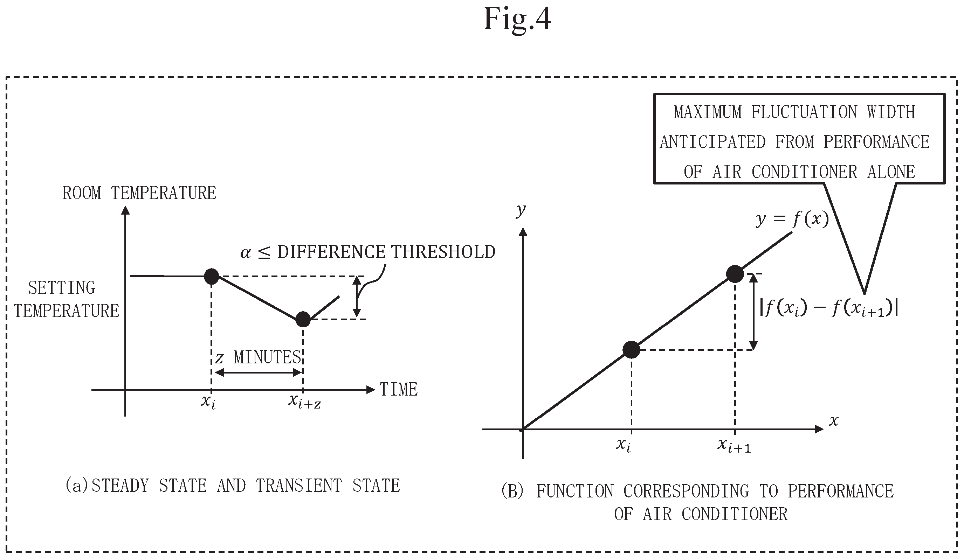

With referring to Fig. 4, a calculation example of the designated period 12 and difference threshold 13 of a case where the time-series data 5 is a room-temperature data series of an air conditioner will be described. Here, each of the designated period 12 and the difference threshold 13 is calculated based on domain knowledge. The example shown in Fig. 4 is aimed at detecting a state that is not a normal state expected from a performance of the air conditioner, character of the room where the air conditioner is installed, and so on.

When the air conditioner is activated, the room temperature transitions to a steady state through a transient state. The transient state refers to a state where the room temperature is increasing or decreasing towards a setting temperature. The steady state is a state where the room temperature is stable at the setting temperature.

After that, as illustrated by (a) of Fig. 4, after the air conditioner stopped as it reached the steady state, when the room temperature gradually decreased or increased over a period of z minutes and accordingly the setting temperature and the room temperature deviate from each other by a threshold or more, the air conditioner transitions back to the transient state. Here, the difference between time $x_{i+z}$ and time $x_i$ is z minutes. Also, the designated period 12 is set at 10 minutes. Assuming the threshold as $\alpha$, a fluctuation width in which the room temperature naturally decreases or increases without being influenced by any environmental factors can be defined as "|(setting temperature) - (room temperature)| < $\alpha$".

Assuming that $\alpha$ is a room temperature that can be returned to the setting temperature within the designated period 12 based on the capacity of the air conditioner, then "$\alpha \leq$ (difference threshold 13)".

When the value of the room temperature changes beyond the difference threshold 13 within the designated period 12, it is interpreted that some environmental factors such as ventilation or human traffic have occurred, and compressed data 14 is generated to save the value of the changed room temperature value.

In setting the difference threshold 13, it is sufficient to grasp that "the air conditioner raises or lowers the room temperature by y degrees over a period of x minutes" from a capacity of the air conditioner (for example, a cooling capacity of 2.8 kW and a heating capacity of 3.6 kW) and the size of the room where the air conditioner is installed. Here, if the change y in room temperature can be defined as a function y = f(x) of a performance f of the air conditioner and time x, it is possible to identify the maximum fluctuation width per unit of time, as shown by (b) of Fig. 4. In (b) of Fig. 4, $(x_{i+1} - x_i)$ corresponds to the unit of time, and "$|f(x_i) - f(x_{i+1})|$" is the maximum room temperature fluctuation width anticipated from the performance alone per unit of time of the air conditioner.

If a temperature sensor measures room temperature with a unitary granularity of 0.5 degree, the difference threshold 13 corresponding to transition of time $x_i$ to time $x_{i+1}$ will be as shown in [Formula 1]. As a specific example, if a change in room temperature at a certain time point is $f(x_1 = 1) = 15.5$ and if $f(x_2 = 2) = 18.5$, the difference threshold 13 based on domain knowledge will be as shown in [Formula 2].

[Formula 1]

$$\text{Difference threshold 13} = \left\lfloor \frac{|f(x_i) - f(x_{i+1})|}{0.5} \right\rfloor \cdot 0.5$$

[Formula 2]

$$\text{Difference threshold 13} = \left\lfloor \frac{|15.5 - 18.5|}{0.5} \right\rfloor \cdot 0.5 = \lfloor 6.0 \rfloor \cdot 0.5 = 6.0/2 = 3.0$$

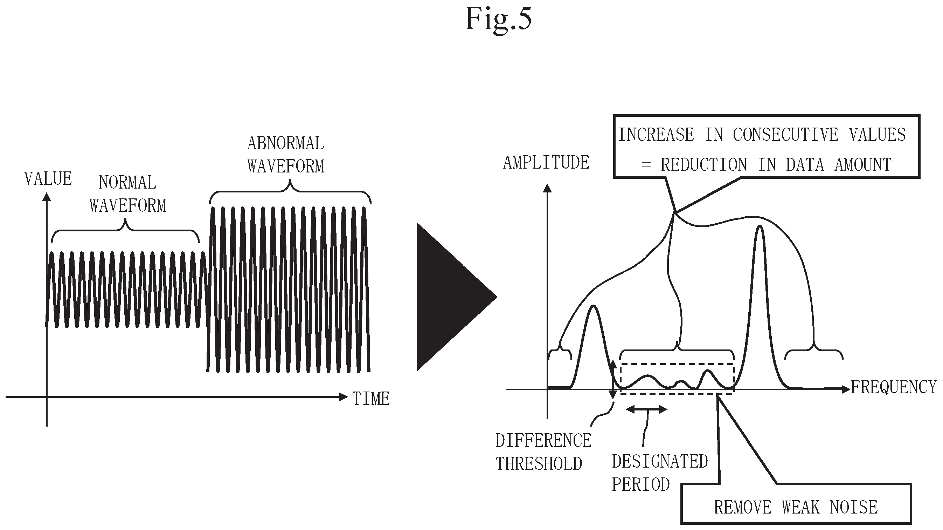

Aside from the air conditioner, another use case involves data of a vibration sensor used to detect tool wear in a machine tool installed in a factory or the like, as shown in Fig. 5.

Here, the vibration waveform changes periodically, it does not include consecutive values, as shown on the left side of Fig. 5. If, however, the vibration waveform is transformed by Fourier transform or the like, data including a large number of a certain kind of consecutive values may appear, as shown on the right side of Fig. 5. When such data is compressed by removing weak noise from the data based on the designated period 12 and the difference threshold 13, the amount of data can be reduced. In addition, information indicating each of a normal waveform and an abnormal waveform is retained in the compressed data 14.

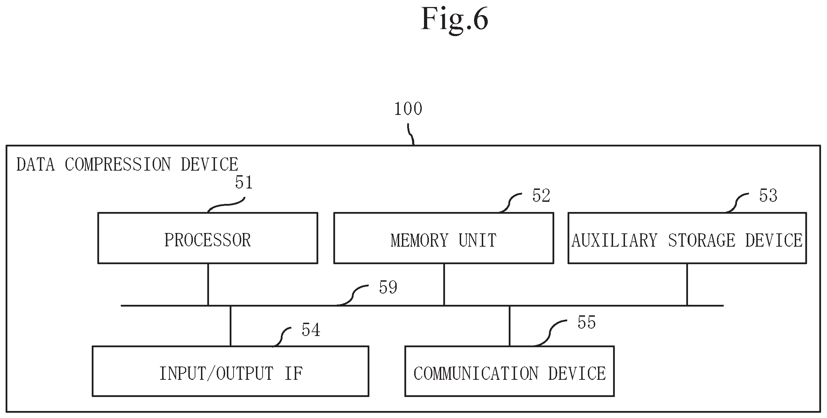

Fig. 6 illustrates a hardware configuration example of the data compression device 100 according to the present embodiment. The data compression device 100 consists of a computer. The data compression device 100 may consist of a plurality of computers.

As illustrated in Fig. 6, the data compression device 100 is a computer equipped with hardware devices such as a processor 51, a memory unit 52, an auxiliary storage device 53, an input/output IF (Interface) 54, and a communication device 55. These hardware devices are appropriately connected to each other via a signal line 59.

The processor 51 is an IC (Integrated Circuit) that performs computation processing and controls the hardware devices that the computer is equipped with. Specific examples of the processor 51 include a CPU (Central Processing Unit), a DSP (Digital Signal Processor), and a GPU (Graphics Processing Unit).

The data compression device 100 may include a plurality of processors as an alternative to the processor 51. The plurality of processors share the role of the processor 51.

The memory unit 52 is typically a volatile storage device, specifically, for instance, a RAM (Random Access Memory). The memory unit 52 is also referred to as the main storage device or main memory unit. Data stored in the memory unit 52 is saved in the auxiliary storage device 53 as needed.

The auxiliary storage device 53 is typically a non-volatile storage device, specifically, for instance, a ROM (Read Only Memory), an HDD (Hard Disk Drive), or a flash memory. Data stored in the auxiliary storage device 53 is loaded into the memory unit 52 as needed.

The memory unit 52 and the auxiliary storage device 53 may be configured integrally.

The input/output IF 54 is a port to which input and output devices are connected. The input/output IF 54 is, for instance, a USB (Universal Serial Bus) terminal. The input devices are, for example, a keyboard and mouse. The output device is, for example, a display.

The communication device 55 is constituted of a receiver and a transmitter. As a specific example, the communication device 55 is a communication chip or an NIC (Network Interface Card).

Each section of the data compression device 100 may appropriately use the input/output IF 54 and the communication device 55 when communicating with other devices and so on.

The auxiliary storage device 53 stores a data compression program. The data compression program is a program that causes the computer to implement the feature of each section of the data compression device 100. The data compression program is loaded into the memory unit 52 and executed by the processor 51. The feature of each section of the data compression device 100 is implemented by software.

Data used when executing the data compression program, data obtained by executing the data compression program, and so on are appropriately stored in the storage device. Each section of the data compression device 100 appropriately utilizes the storage device. The storage device includes, for example, at least one of the memory unit 52, the auxiliary storage device 53, a register in the processor 51, and a cache memory in the processor 51. It should be noted that the term "data" and the term "information" may sometimes have the same meaning. The storage device may be independent of the computer.

The features of the memory unit 52 and auxiliary storage device 53 can be implemented by other storage devices.

The data compression program may be recorded on a computer readable non-volatile recording medium. As a specific example, the non-volatile recording medium is an optical disc or a flash memory. The data compression program may be provided as a program product.

*** Description of Operation ***

An operation procedure of the data compression system 90 corresponds to a data compression method. Furthermore, a program that realizes the operation of the data compression system 90 corresponds to the data compression program.

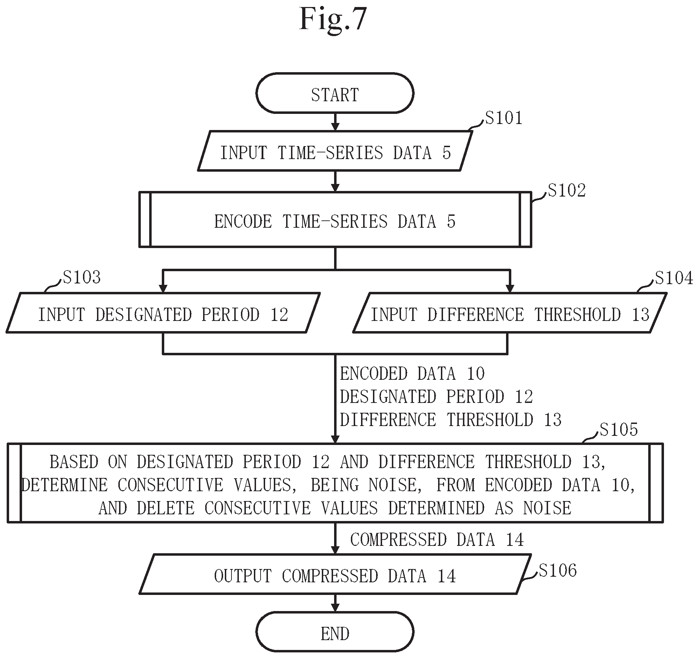

Fig. 7 is a flowchart illustrating an example of processing of the data compression device 100. The processing of the data compression device 100 will be described with referring to Fig. 7.

(Step S101)

The data reception unit 7 receives the time-series data 5 and sends the received time-series data 5 to the encoding unit 9.

(Step S102)

The encoding unit 9 receives the time-series data 5 from the data reception unit 7, and generates the encoded data 10 by encoding the received time-series data 5, then sends the generated encoded data 10 to the noise determination unit 11.

(Step S103)

The designated period 12 is inputted to the noise determination unit 11.

(Step S104)

The difference threshold 13 is inputted to the noise determination unit 11.

(Step S105)

The noise determination unit 11 receives the encoded data 10, and generates the compressed data 14 using the received encoded data 10, the inputted designated period 12, and the inputted difference threshold 13. At this time, the noise determination unit 11 detects consecutive values whose durations are shorter than the designated period 12. Then, from among the detected consecutive values in the encoded data 10, the noise determination unit 11 deletes each consecutive value whose difference from the value of a data point immediately preceding the start point of the consecutive value in a time-series manner is less than or equal to the difference threshold 13.

(Step S106)

The noise determination unit 11 outputs the generated compressed data 14.

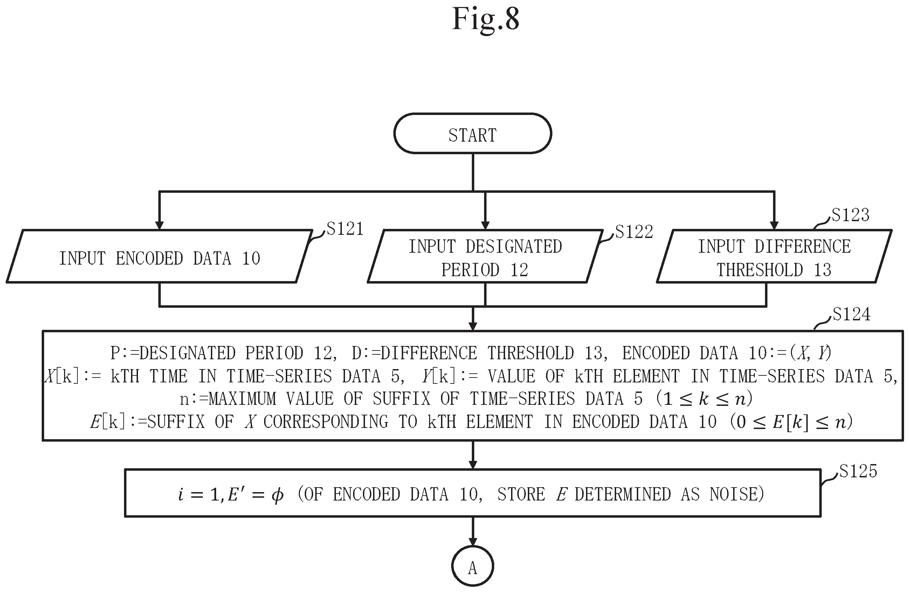

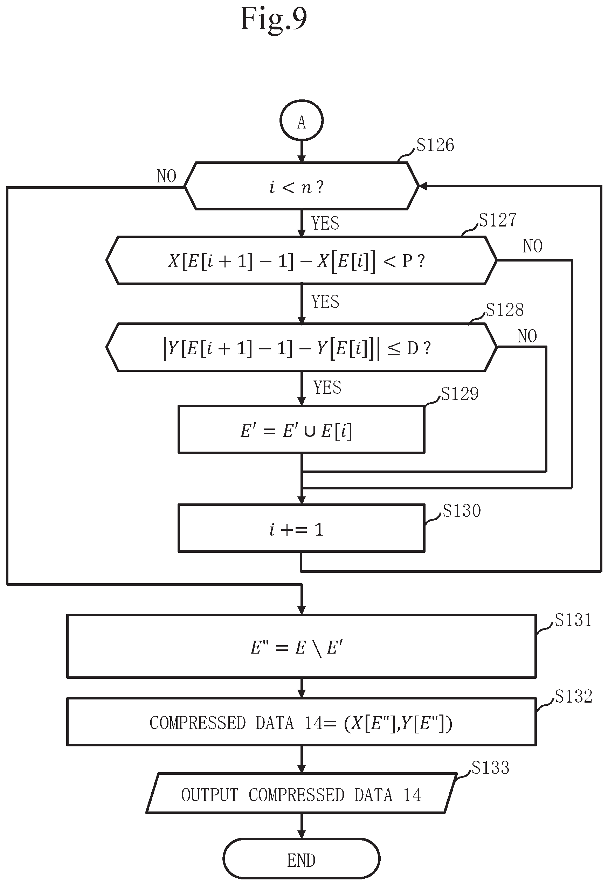

Fig. 8 and Fig. 9 are flowcharts illustrating an example of processing of the noise determination unit 11. With referring to Fig. 8 and Fig. 9, the processing of the noise determination unit 11 will be described.

(Step S121)

The encoded data 10 is inputted to the noise determination unit 11.

(Step S122)

The designated period 12 is inputted to the noise determination unit 11 .

(Step S123)

The difference threshold 13 is inputted to the noise determination unit 11.

(Step S124)

The noise determination unit 11 uses a constant P to refer to a value indicated by the designated period 12, a constant D to refer to a value indicated by the difference threshold 13, and uses (X,Y) to express the encoded data 10. Herein, $X[k]$ $(1 \leq k \leq n)$ represents time that is kth in the time-series data 5 in a time-series manner, and $Y[k]$ represents a value at the time that is kth in the time-series data 5 in a time-series manner. Also, n represents the maximum value of the suffix of the time-series data 5. Note that $E[k]$ $(0 \leq E[k] \leq n)$ signifies a suffix of X corresponding to a data point that is kth in the encoded data 10 in a time-series manner.

(Step S125)

The noise determination unit 11 assigns 1 to a variable i and uses E' to refer to an empty set. Of the encoded data 10, E that was determined to be noise is sequentially stored to E'.

(Step S126)

If i < n is satisfied, the noise determination unit 11 proceeds to step S127. Otherwise, the noise determination unit 11 proceeds to step S131.

(Step S127)

If $X[E[i + 1] - 1] - X[E[i]] < P$ is satisfied, the noise determination unit 11 proceeds to step S128. Otherwise, the noise determination unit 11 proceeds to step S130.

(Step S128)

If $|Y[E[i + 1] - 1] - Y[E[i]]| \leq D$ is satisfied, the noise determination unit 11 proceeds to step S129. Otherwise, the noise determination unit 11 proceeds to step S130.

(Step S129)

The noise determination unit 11 adds $E[i]$ to E'.

(Step S130)

The noise determination unit 11 increments the value of the variable i by 1.

(Step S131)

The noise determination unit 11 uses E" to refer to a difference set between E and E'. Here, A\B refers to a difference set obtained by subtracting a set B from a set A.

(Step S132)

The noise determination unit 11 uses (X[E"], Y[E"]) to express the compressed data 14.

(Step S133)

The noise determination unit 11 outputs the generated compressed data 14.

*** Explanation of the Effects of Embodiment 1 ***

As described above, according to the present embodiment, in a case where time-series data includes many consecutive values, each data point at a time point at which a predetermined period of time has elapsed is not saved, as described in Patent Literature 1. Therefore, it is possible to further compress the time-series data.

Also, according to the present embodiment, even when fluctuations equal to or smaller than the difference threshold 13 occur, if consecutive values immediately after the fluctuations last for the designated period 12 or more, information indicating the consecutive values is retained in the compressed data 14. Thus, significant change points in machine learning are not discarded. Here, in machine learning, if a value has larger fluctuations, that is, if a value has larger variances, often the value has a greater impact on predictions. In the present embodiment, points with large fluctuations are actively retained, while only noise that has little or no impact on the accuracy of the machine learning model is removed. Therefore, according to the present embodiment, the amount of data is reduced while the accuracy is maintained, so the data storage cost can be reduced.

In restoration of the compressed data 14, an ordinary difference encoding restoration algorithm is used as a specific example. Therefore, it is not necessary to prepare a special data restoration device in the present embodiment. In addition, the setting values of the designated period 12 and difference threshold 13 do not have impact on the restoration of data, so it is not necessary to retain the designated period 12 and the difference threshold 13 as metadata.

Furthermore, the processing of generating the compressed data 14 may sometimes have an effect similar to preprocessing in machine learning. Therefore, improvement in the accuracy is expected depending on the machine learning model (training algorithm).

*** Other Configurations ***

< Modification 1 >

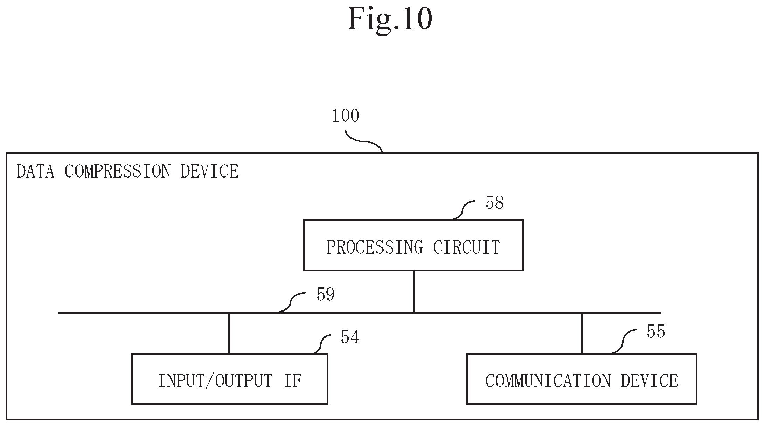

Fig. 10 illustrates a hardware configuration example of a data compression device 100 according to the present modification.

The data compression device 100 is equipped with a processing circuit 58 in place of: the processor 51; the processor 51 and the memory unit 52; the processor 51 and the auxiliary storage device 53; or the processor 51, the memory unit 52, and the auxiliary storage device 53.

The processing circuit 58 is hardware that implements at least part of each section equipped in the data compression device 100.

The processing circuit 58 may be dedicated hardware, or a processor that executes a program stored in the memory unit 52.

When the processing circuit 58 is dedicated hardware, specific examples of the processing circuit 58 include a single circuit, a composite circuit, a programmed processor, a parallel-programmed processor, an ASIC (Application Specific Integrated Circuit), an FPGA (Field Programmable Gate Array), or a combination of these.

The data compression device 100 may include a plurality of processing circuits as an alternative to the processing circuit 58. The plurality of processing circuits share the role of the processing circuit 58.

In the data compression device 100, some features may be implemented by dedicated hardware, and the remaining features may be implemented by software or firmware.

In a specific example, the processing circuit 58 is implemented by hardware, software, firmware, or a combination thereof.

The processor 51, the memory unit 52, the auxiliary storage device 53, and the processing circuit 58 are collectively referred to as "processing circuitry". In other words, the features of the feature constituent components of the data compression device 100 are implemented by processing circuitry.

A data compression device 100 according to another embodiment may also have the same configuration as that of the present modification.

Embodiment 2.

Below, the aspects that differ from the previously mentioned embodiment will mainly be described with referring to drawings.

*** Description of Configuration ***

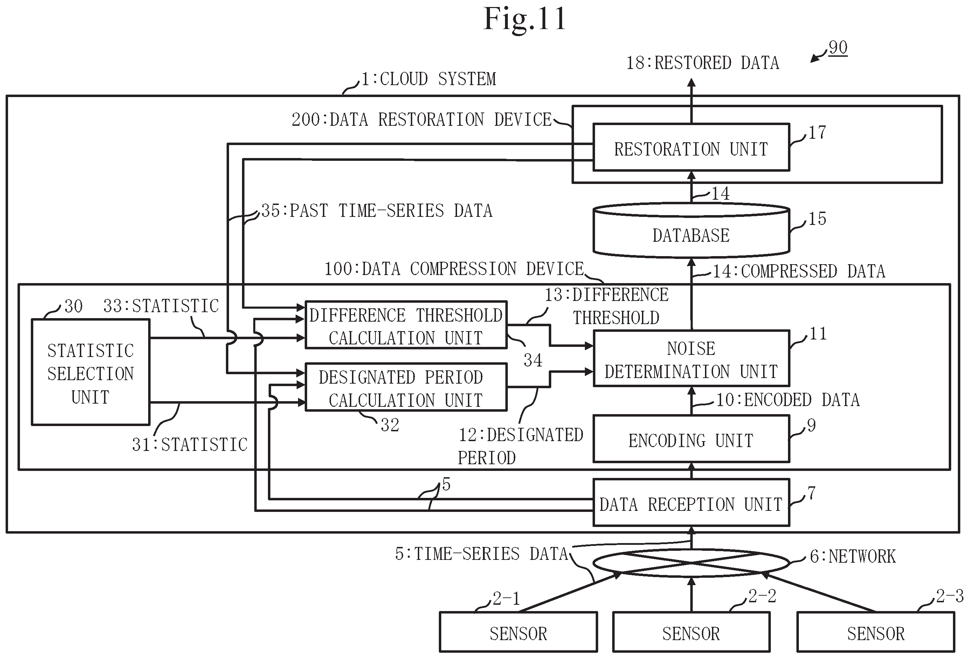

Fig. 11 illustrates a configuration example of a data compression system 90 according to the present embodiment.

A data compression device 100 according to the present embodiment further includes a statistic selection unit 30, a designated period calculation unit 32, and a difference threshold calculation unit 34. The data compression device 100 may be implemented by an edge system 19.

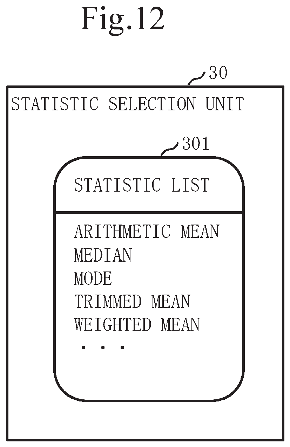

Fig. 12 illustrates a configuration example of the statistic selection unit 30. The statistic selection unit 30 selects a statistic 31 and a statistic 33 from a statistic list 301 as appropriate.

The statistic 31 is a statistic used when calculating a designated period 12.

The statistic 33 is a statistic used when calculating a difference threshold 13.

Note that the statistic 31 and the statistic 33 can be different statistics.

The statistic list 301 is a list showing statistics. In a specific example, the statistic list 301 consists of data representing "arithmetic mean", "median", "mode", "trimmed mean", and "weighted mean".

The designated period calculation unit 32 calculates the designated period 12 based on a durations of each consecutive value included in each time-series data 5. Specifically, the designated period calculation unit 32 takes the statistic 31, past time-series data 35, and the time-series data 5 as input and calculates the designated period 12. The past time-series data 35 is data restored from compressed data 14 generated in the past. The past time-series data 35 may be time-series data 5 acquired in the past.

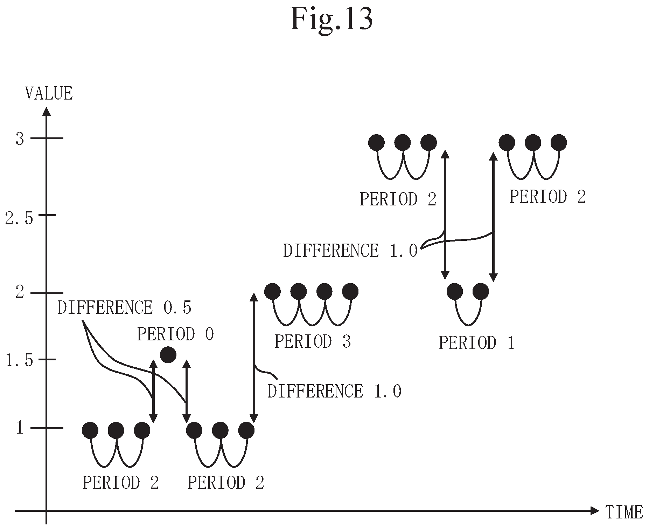

In a specific example, when determining the designated period 12 using arithmetic mean, the designated period calculation unit 32 calculates the designated period 12 by [Formula 3]. If the time-series data 5 shown in Fig. 13 is the input, the designated period calculation unit 32 calculates the designated period 12 as shown in [Formula 4].

[Formula 3]

$$\text{Designated period } 12 = \frac{\sum_{i=1}^{n} \text{Period } i}{n}$$

[Formula 4]

$$\text{Designated period } 12 = \frac{2 + 0 + 2 + 3 + 2 + 1 + 2}{7} = \frac{12}{7} \fallingdotseq 1.714$$

The difference threshold calculation unit 34 calculates the difference threshold 13 based on a difference between a value of each consecutive value included in the time-series data 5 and a value of a data point immediately preceding the start point in a time-series manner of that consecutive value. Specifically, the difference threshold calculation unit 34 takes the statistic 33, the past time-series data 35, and the time-series data 5 as input and calculates the difference threshold 13.

In a specific example, when determining the difference threshold 13 using arithmetic mean, the difference threshold calculation unit 34 calculates the difference threshold 13 by [Formula 5]. If time-series data 5 shown in Fig. 13 is the input, the designated period calculation unit 32 calculates the difference threshold 13 as shown in [Formula 6].

[Formula 5]

$$\text{Difference threshold } 13 = \frac{\sum_{i=1}^{m} \text{Difference } i}{m}$$

[Formula 6]

$$\text{Difference threshold } 13 = \frac{0.5 + 0.5 + 1.0 + 1.0 + 1.0}{5} = \frac{4.0}{5} = 0.8$$

*** Description of Operation ***

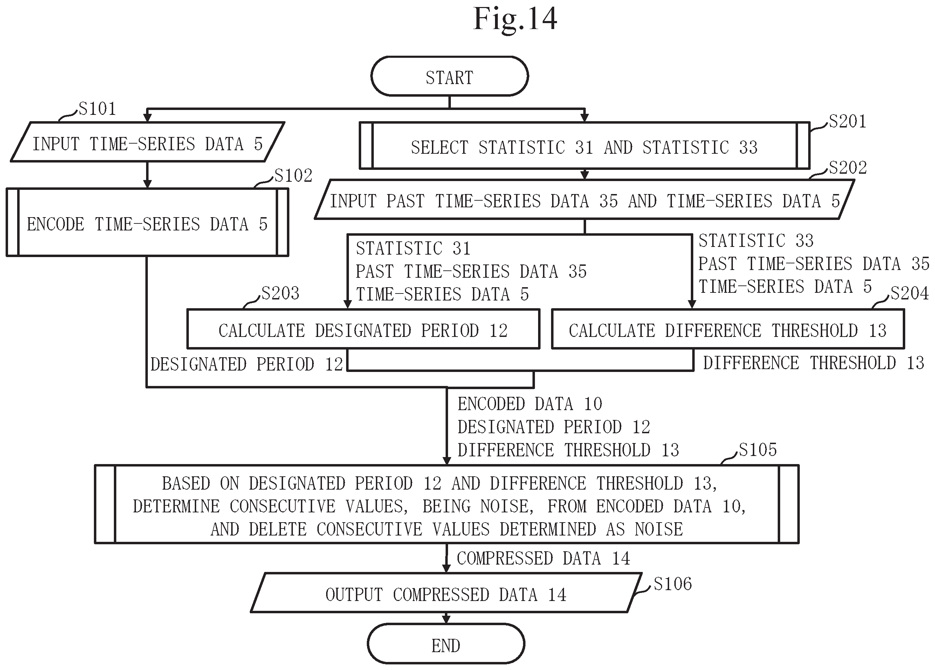

Fig. 14 is a flowchart illustrating an example of processing of the data compression system 90. With referring to Fig. 14, the processing of the data compression system 90 will be described.

(Step S201)

The statistic selection unit 30 selects the statistic 31 and the statistic 33.

(Step S202)

The time-series data 5 and the past time-series data 35 are inputted to each of the designated period calculation unit 32 and the difference threshold calculation unit 34.

(Step S203)

The designated period calculation unit 32 calculates the designated period 12.

(Step S204)

The difference threshold calculation unit 34 calculates the difference threshold 13.

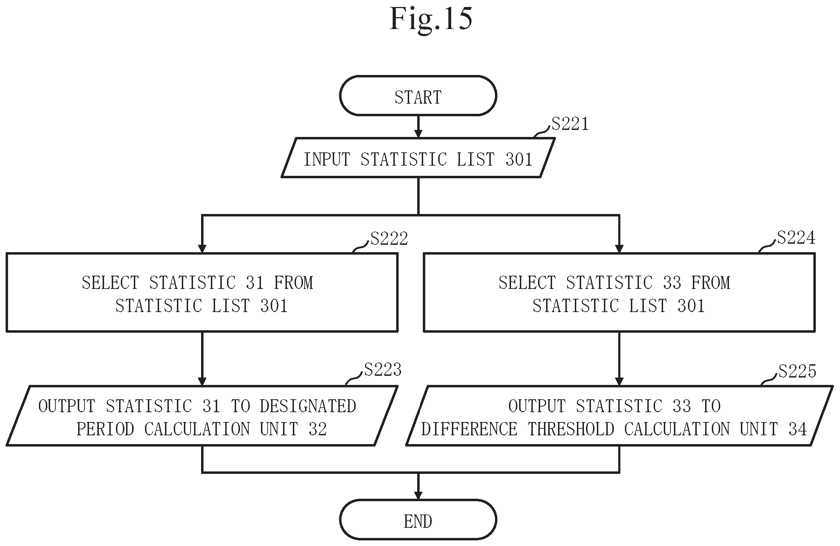

Fig. 15 is a flowchart illustrating an example of processing of the statistic selection unit 30. With referring to Fig. 15, the processing of the statistic selection unit 30 will be described.

(Step S221)

The statistic list 301 is inputted to the statistic selection unit 30.

(Step S222)

The statistic selection unit 30 selects, from the statistics indicated by the statistic list 301, a statistic used in calculating the designated period 12, as the statistic 31.

(Step S223)

The statistic selection unit 30 outputs the selected statistic 31 to the designated period calculation unit 32.

(Step S224)

The statistic selection unit 30 selects, from the statistics indicated by the statistic list 301, a statistic used in calculating the difference threshold 13, as the statistic 33.

(Step S225)

The statistic selection unit 30 outputs the selected statistic 33 to the difference threshold calculation unit 34.

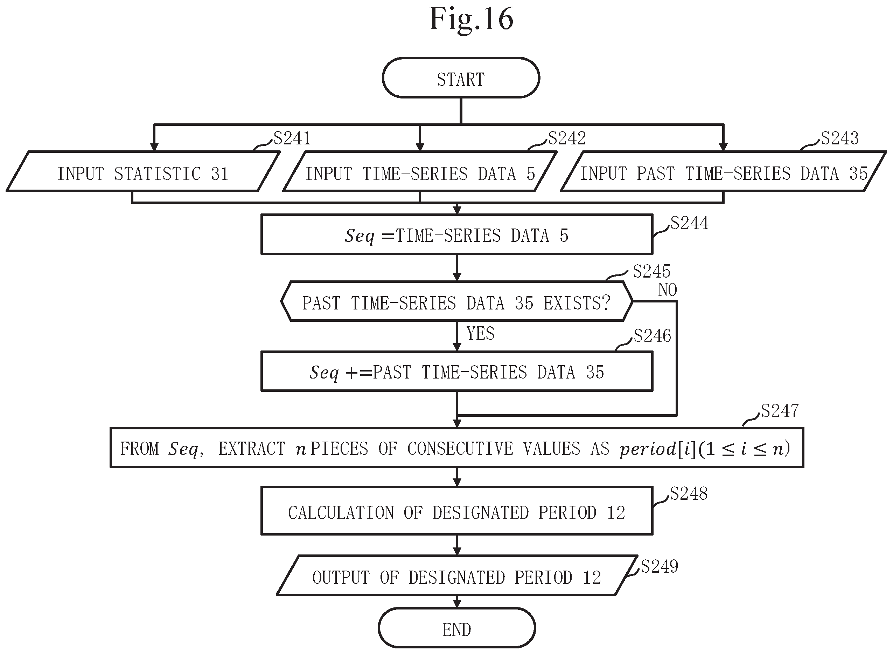

Fig. 16 is a flowchart illustrating an example of processing of the designated period calculation unit 32. With referring to Fig. 16, the processing of the designated period calculation unit 32 will be described.

(Step S241)

The statistic 31 is inputted to the designated period calculation unit 32.

(Step S242)

The time-series data 5 is inputted to the designated period calculation unit 32.

(Step S243)

The past time-series data 35 is inputted to the designated period calculation unit 32.

(Step S244)

The designated period calculation unit 32 assigns the time-series data 5 to a variable Seq.

(Step S245)

If the past time-series data 35 exists, the designated period calculation unit 32 proceeds to step S246. Otherwise, the designated period calculation unit 32 proceeds to step S247.

(Step S246)

The designated period calculation unit 32 adds the past time-series data 35 to the variable Seq.

(Step S247)

The designated period calculation unit 32 extracts n pieces of consecutive values from the time-series data indicated by the variable Seq, as period[i] ($1 \leq i \leq n$).

(Step S248)

The designated period calculation unit 32 calculates the designated period 12 in accordance with the inputted statistic 31.

(Step S249)

The designated period calculation unit 32 outputs the calculated designated period 12 to the noise determination unit 11.

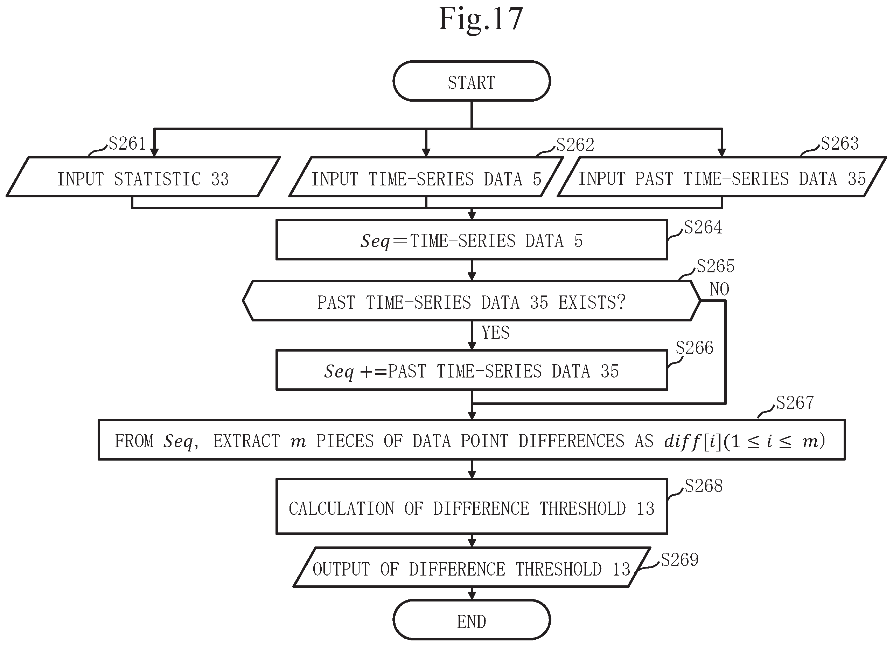

Fig. 17 is a flowchart illustrating an example of processing of the difference threshold calculation unit 34. The processing of the difference threshold calculation unit 34 will be described with referring to Fig. 17.

(Step S261)

The statistic 33 is inputted to the difference threshold calculation unit 34.

(Step S262)

The time-series data 5 is inputted to the difference threshold calculation unit 34.

(Step S263)

The past time-series data 35 is inputted to the difference threshold calculation unit 34.

(Step S264)

The difference threshold calculation unit 34 assigns the time-series data 5 to the variable Seq.

(Step S265)

If past time-series data 35 exists, the difference threshold calculation unit 34 proceeds to step S266. Otherwise, the difference threshold calculation unit 34 proceeds to step S267.

(Step S266)

The difference threshold calculation unit 34 adds the past time-series data 35 to the variable Seq.

(Step S267)

The difference threshold calculation unit 34 extracts, from the time-series data indicated by the variable Seq, differences of m pieces of data differences, as diff[i] ($1 \leq i \leq m$).

(Step S268)

The difference threshold calculation unit 34 calculates the difference threshold 13 in accordance with the inputted statistic 33.

(Step S269)

The difference threshold calculation unit 34 outputs the calculated difference threshold 13 to the noise determination unit 11.

*** Explanation of Effect of Embodiment 2 ***

As mentioned above, according to the present embodiment, the designated period 12 and the difference threshold 13 are calculated based on the time-series data and the selected statistic. Therefore, it is not necessary make determination on each of the designated period 12 and the difference threshold 13 for each data series, in other words, domain knowledge is unnecessary.

Moreover, according to the present embodiment, since the user parameter decreases, the ease of use improves.

Embodiment 3.

Below, the points that are different from the previously mentioned embodiment will mainly be described with referring to the drawings.

*** Description of Configuration ***

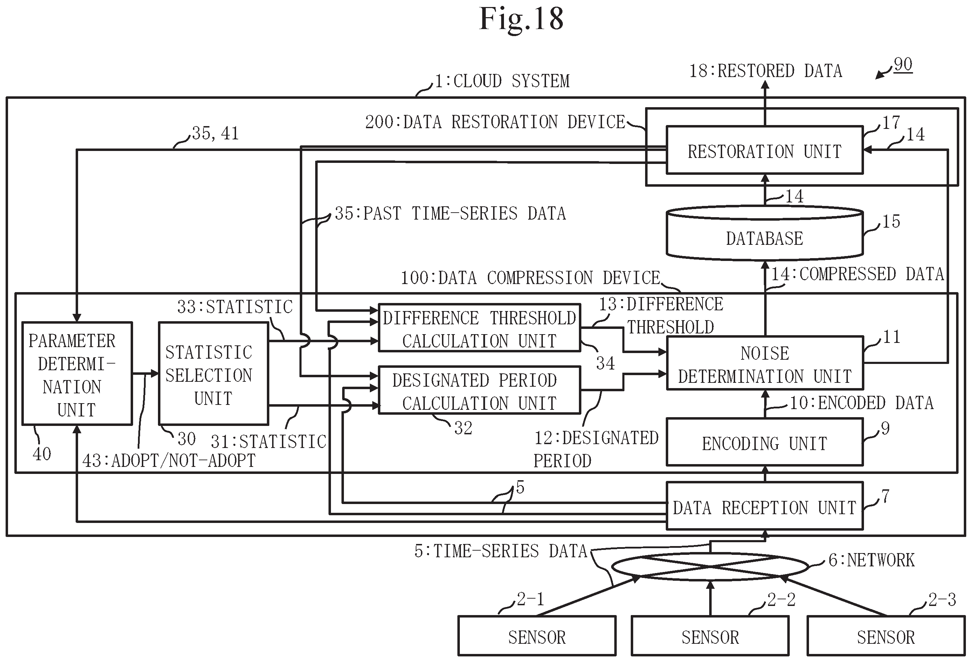

Fig. 18 illustrates a configuration example of a data compression system 90 according to the present embodiment.

A data compression device 100, in comparison to the data compression device 100 according to Embodiment 2, further includes a parameter determination unit 40. Note that the data compression device 100 according to Embodiment 1 may also further include a parameter determination unit 40.

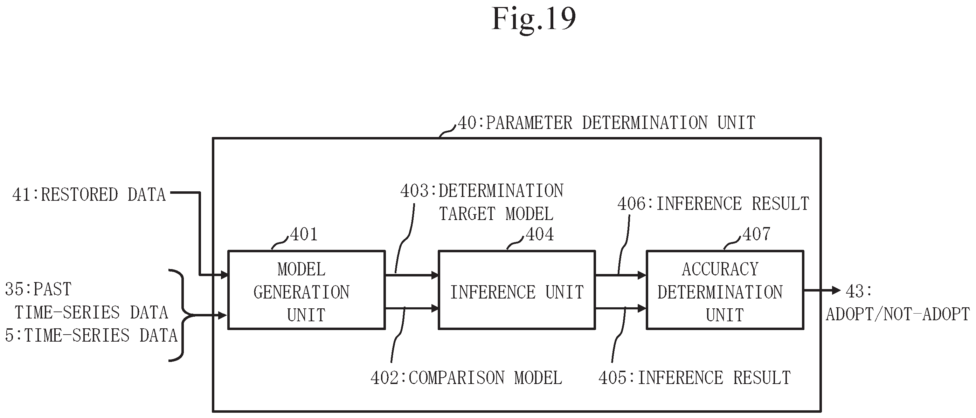

Fig. 19 illustrates a configuration example of the parameter determination unit 40. The parameter determination unit 40 includes a model generation unit 401, an inference unit 404, and an accuracy determination unit 407.

The parameter determination unit 40 determines whether or not to adopt each of a calculated designated period 12 and a calculated difference threshold 13 based on an accuracy of a machine learning model trained using data restored from compressed data 14, to an accuracy of a machine learning model trained using time-series data 5.

The model generation unit 401 generates a comparison model 402 using the time-series data 5, and generates a determination target model 403 using restored data 41. The restored data 41 is data that the restoration unit 17 has restored from the compressed data 14, and is time-series data to be determined. Each of the comparison model 402 and the determination target model 403 is a machine learning model.

The model generation unit 401 may use past time-series data 35 when generating the comparison model 402. The past time-series data 35 is time-series data generated by the restoration unit 17 extracting the past compressed data 14 from a database 15 and restoring the extracted compressed data 14.

The inference unit 404 calculates an inference result 405 by executing inference using the comparison model 402, and calculates an inference result 406 by executing inference using the determination target model 403. Each of the inference result 405 and the inference result 406 is a predictive value. The inference result 406 corresponds to a determination target.

The accuracy determination unit 407 determines whether an accuracy of a machine learning model corresponding to the compressed data 14 is tolerable or not by measuring an inference error using the inference result 405 and the inference result 406.

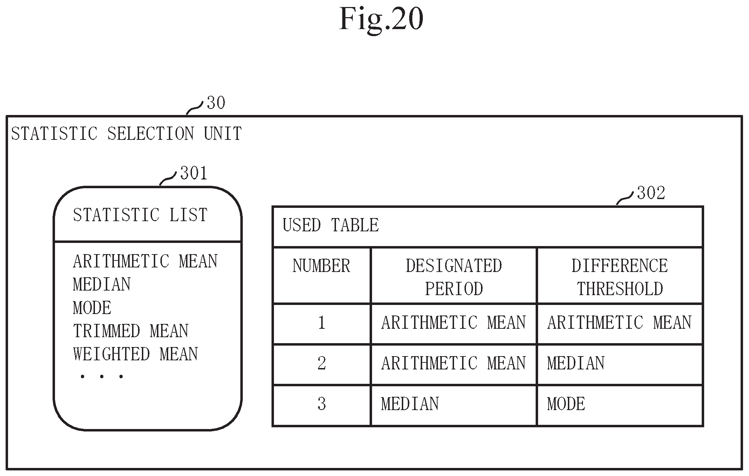

Fig. 20 illustrates a configuration example of a statistic selection unit 30 according to the present embodiment. The statistic selection unit 30 further includes a used table 302.

The used table 302 is table data that holds statistics determined by the parameter determination unit 40 and manages used statistics. The used table 302 may hold pairs each consisting of a statistic corresponding to a designated period 12 and a statistic corresponding to a difference threshold 13, as illustrated in Fig. 20. In the used table 302, a used table corresponding to the designated period 12 and a used table corresponding to the difference threshold 13 may exist.

The statistic selection unit 30 selects a statistic that is not included in the used table 302 from a statistic list 301. If pairs each consisting of statistics are held in the used table 302, the statistic selection unit 30 may select a combination of statistics not included in the used table 302 .

The statistic selection unit 30 records used statistics to the used table 302.

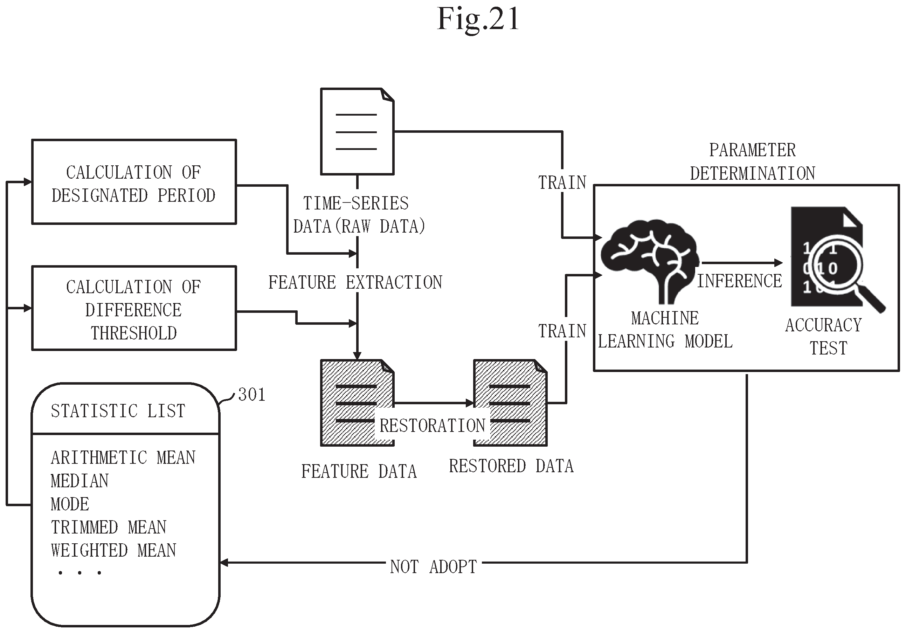

Fig. 21 illustrates an image of processing of the data compression system 90 according to the present embodiment.

The parameter determination unit 40 creates a machine learning model using raw data and time-series data which is restored from the compressed data 14, and based on a difference in inference accuracy between the two created machine learning models, determines whether or not to adopt the designated period 12 and the difference threshold 13 which are used when generating the compressed data 14. If the parameter determination unit 40 determines not to adopt the designated period 12 and the difference threshold 13, the statistic selection unit 30 selects again the statistics used in the calculation of the designated period 12 and difference threshold 13. The parameter determination unit 40 may execute determination of adoption for only one of the designated period 12 and the difference threshold 13, or may execute the determination of adoption for the designated period 12 and the difference threshold 13 simultaneously or sequentially.

The machine learning model to be compared with the machine learning model corresponding to the restored data 41 may be a machine learning model trained using data collected so far. The parameter determination unit 40 may adopt a combination of a designated period 12 and a difference threshold 13 that minimizes the error of the accuracy of the machine learning model corresponding to the accuracy the raw data.

*** Description of Operation ***

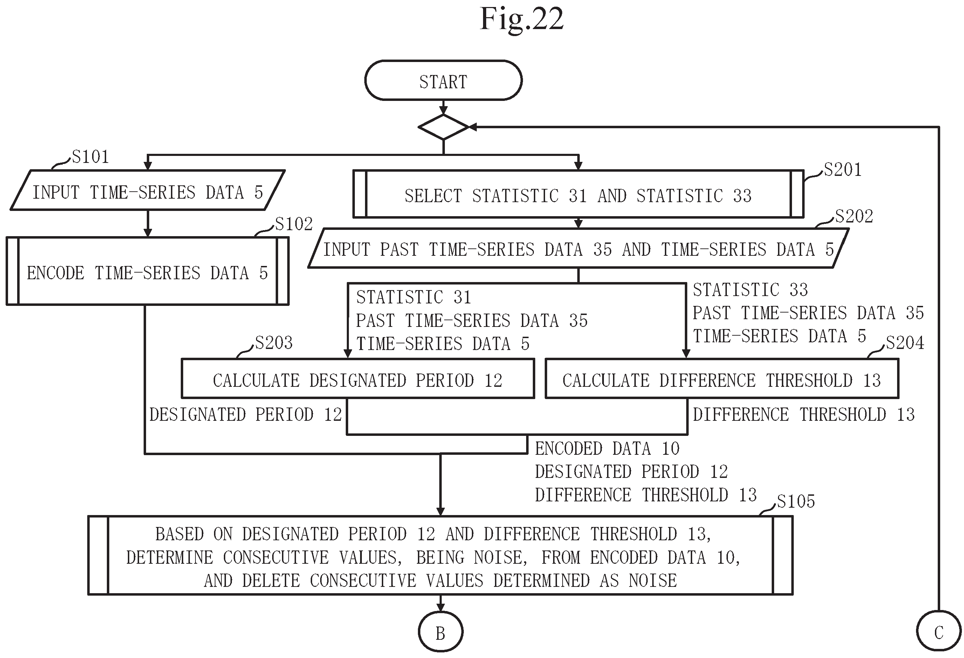

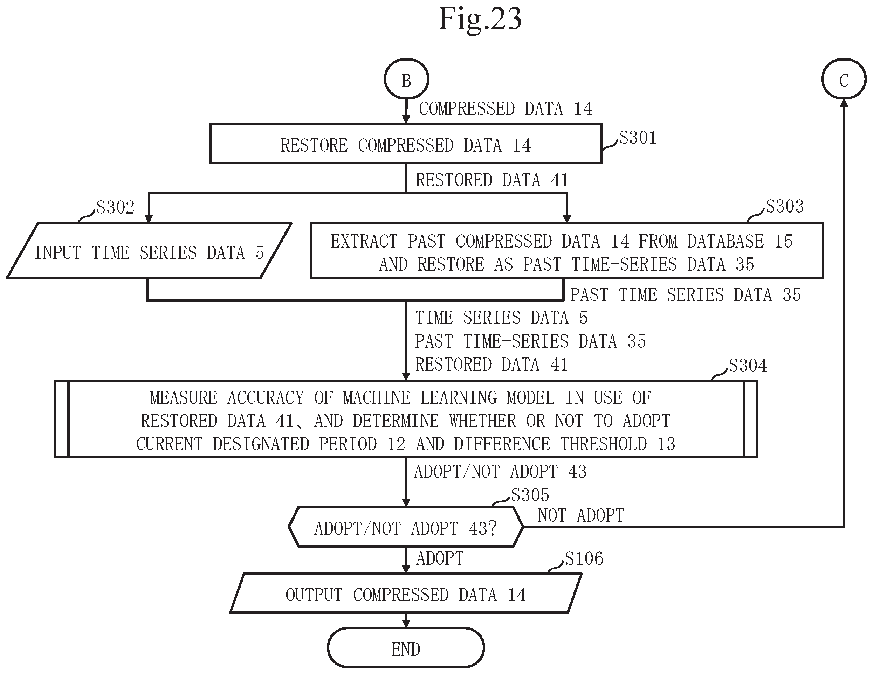

Fig. 22 and Fig. 23 are flowcharts illustrating an example of the processing of the data compression system 90. The processing of the data compression system 90 will be described with referring to Fig. 22 and Fig. 23.

(Step S301)

The restoration unit 17 generates the restored data 41 by restoring the compressed data 14 generated by a noise determination unit 11.

(Step S302)

The time-series data 5 is inputted to the parameter determination unit 40.

(Step S303)

The restoration unit 17 extracts each compressed data 14 generated in the past from the database 15 and restores each extracted compressed data 14 into the past time-series data 35.

(Step S304)

The parameter determination unit 40 measures the accuracy of the machine learning model corresponding to the restored data 41, and determines whether or not to adopt the current designated period 12 and difference threshold 13 based on the measurement result.

(Step S305)

If the current designated period 12 and the current difference threshold 13 are adopted, the data compression system 90 proceeds to step S106. If the current designated period 12 and the difference threshold 13 are not adopted, the data compression system 90 repeatedly executes the processing of these flowcharts.

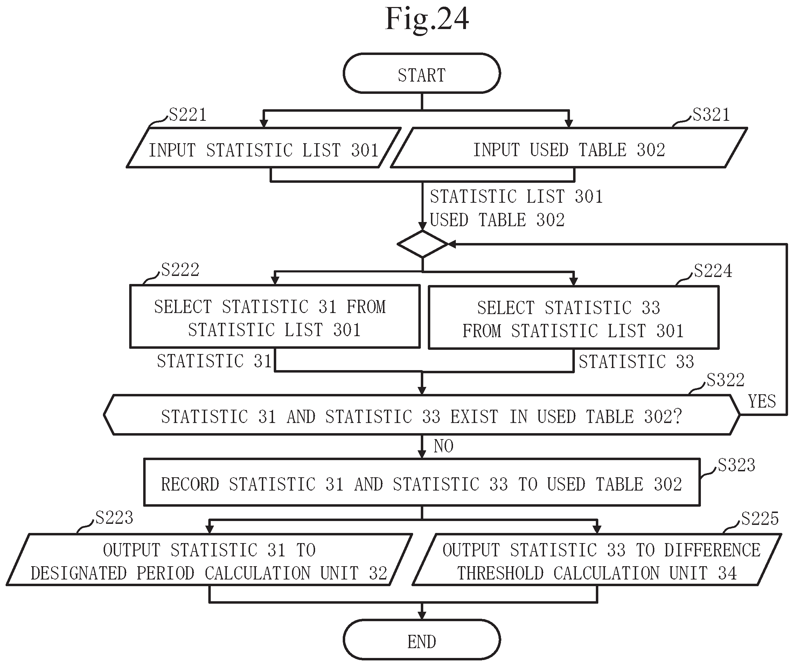

Fig. 24 is a flowchart illustrating an example of processing of the statistic selection unit 30. With referring to Fig. 24, the processing of the statistic selection unit 30 will be described.

(Step S321)

The used table 302 is inputted to the statistic selection unit 30.

(Step S322)

If the selected statistic 31 and the selected statistic 33 exist in the used table 302, the statistic selection unit 30 returns to the process of selecting each statistic. Otherwise, the statistic selection unit 30 proceeds to step S323.

(Step S323)

The statistic selection unit 30 records the selected statistic 31 and the selected statistic 33 to the used table 302.

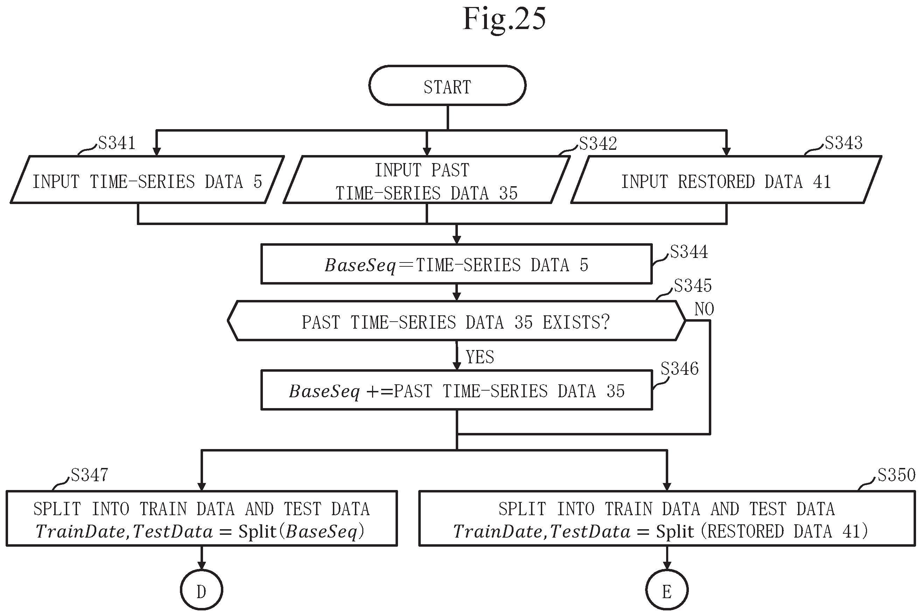

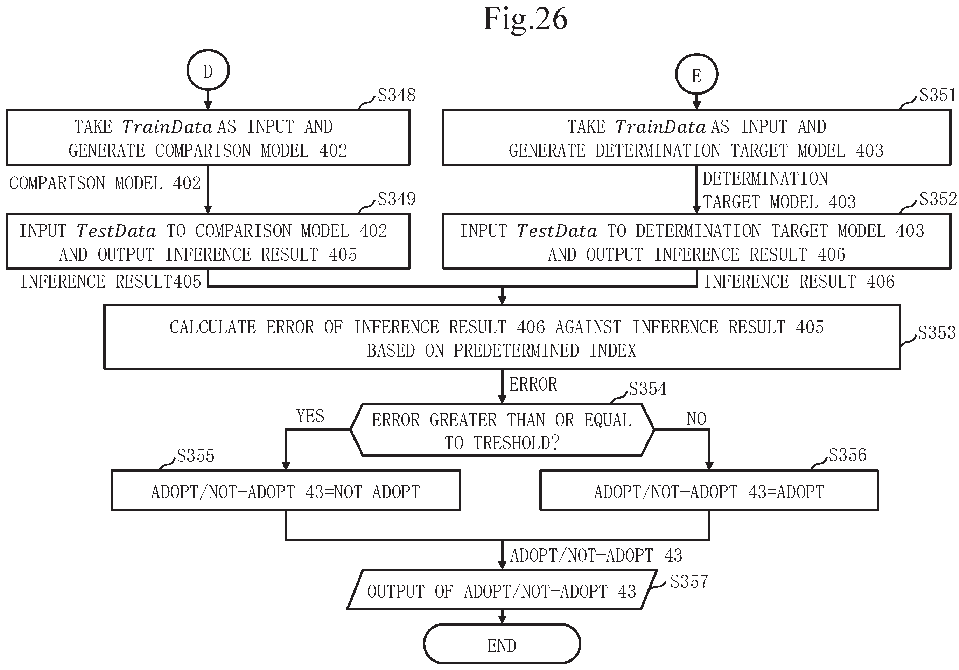

Fig. 25 and Fig. 26 are flowcharts that illustrate an example of processing of the parameter determination unit 40. With referring to Fig. 25 and Fig. 26, the processing of the parameter determination unit 40 will be described.

(Step S341)

The time-series data 5 is inputted to the parameter determination unit 40.

(Step S342)

The past time-series data 35 is inputted to the parameter determination unit 40.

(Step S343)

The restored data 41 being the determination target is inputted to the parameter determination unit 40.

(Step S344)

The model generation unit 401 assigns the time-series data 5 to a variable BaseSeq.

(Step S345)

If past time-series data 35 exists, the model generation unit 401 proceeds to step S346. Otherwise, the model generation unit 401 skips step S346.

(Step S346)

The model generation unit 401 adds past time-series data 35 to the variable BaseSeq.

(Step S347)

The model generation unit 401 splits data indicated by the variable BaseSeq into train data (TrainData) and test data (TestData).

(Step S348)

The model generation unit 401 takes the TrainData as input and executes machine learning to generate the comparison model 402 .

(Step S349)

The inference unit 404 inputs TestData to the comparison model 402 generated by the model generation unit 401 and executes inference to generate the inference result 405.

(Step S350)

The model generation unit 401 splits data indicated by the restored data 41 into train data (TrainData) and test data (TestData).

(Step S351)

The model generation unit 401 takes the TrainData as input and executes machine learning to generate the determination target model 403.

(Step S352)

The inference unit 404 inputs TestData to the determination target model 403 generated by the model generation unit 401 and executes inference to generate the inference result 406.

(Step S353)

The accuracy determination unit 407 calculates an error of the inference result 406 against the inference result 405. An error index is, for example, an RSME (Root Mean Squared Error), an MSE (Mean Squared Error), an MAE (Mean Absolute Error), or an MAPE (Mean Absolute Percentage Error).

(Step S354)

If the calculated error is equal to or exceeds a certain threshold, the accuracy determination unit 407 proceeds to step S355. Otherwise, the accuracy determination unit 407 proceeds to step S356.

(Step S355)

The accuracy determination unit 407 determines not-adopt on adopt/not-adopt 43.

(Step S356

The accuracy determination unit 407 determines adopt on adopt/not-adopt 43.

(Step S357)

The parameter determination unit 40 outputs a determination result of adopt/not-adopt 43.

*** Explanation of the Effects of Embodiment 3 ***

As stated above, according to the present embodiment, whether or not to adopt the designated period 12 and the difference threshold 13 is determined based on the error of the machine learning model corresponding to the compressed data 14, against the machine learning model corresponding to the raw data. Therefore, according to the present embodiment, it is possible to automatically determine such designated period 12 and such difference threshold 13 that can minimize the decrease in the inference accuracy of the machine learning model.

*** Other Embodiments ***

Arbitrary combinations of the embodiments mentioned earlier, as well as modification of any constituent element of each embodiment, or omission of any constituent component in each embodiment, are possible.
Moreover, the embodiments are not limited to those indicated in Embodiment 1 to 3, and various changes can be made as necessary. The procedures described using flowcharts and so on may be appropriately modified.

**Reference Signs List**

1: cloud system; 2: sensor; 5: time-series data; 6: network; 7: data reception unit; 9: encoding unit; 10: encoded data; 11: noise determination unit; 12: designated period; 13: difference threshold; 14: compressed data; 15: database; 17: restoration unit; 18: restored data; 19: edge system; 22: restoration method; 30: statistic selection unit; 301: statistic list; 302: used table; 31: statistic; 32: designated period calculation unit; 33: statistic; 34: difference threshold calculation unit; 35: past time-series data; 40: parameter determination unit; 401: model generation unit; 402: comparison model; 403: determination target model; 404: inference unit; 405, 406: inference result; 407: accuracy determination unit; 41: restored data; 43: adopt/not-adopt; 51: processor; 52: memory unit; 53: auxiliary storage device; 54: input/output IF; 55: communication device; 58: processing circuit; 59: signal line; 90: data compression system; 100: data compression device; 200: data restoration device.

**Claims**

1. A data compression device which compresses discrete time-series data including a plurality of consecutive values consisting of time-series consecutive one or more data points indicating identical values,

   the data compression device comprising a noise determination unit which,
   assuming that each consecutive value included in the time-series data is a target consecutive value,
   determines that the target consecutive value is noise if a duration of the target consecutive value is less than a designated period and a difference between a value of the target consecutive value and a value of a data point immediately preceding a start point in a time-series manner of the target consecutive value is less than or equal to a difference threshold,
   determines that the target consecutive value is not noise if the duration of the target consecutive value is equal to or greater than the designated period and the difference between the value of the target consecutive value and the value of the data point immediately preceding the start point in a time-series manner of the target consecutive value is less than or equal to the difference threshold, and
   generates compressed data being data that: does not indicate each consecutive value determined to be noise; indicates each consecutive value determined not to be noise; and is obtained by compressing the time-series data.

2. The data compression device according to claim 1,
   wherein the noise determination unit determines that the target consecutive value is not noise if the difference between the value of the target consecutive value and the value of the data point immediately preceding the start point in a time-series manner of the target consecutive value is greater than the difference threshold.

3. The data compression device according to claim 1 or 2,
   wherein the noise determination unit generates the compressed data by differential encoding.

4. The data compression device according to any one of claims 1 to 3,
   wherein the designated period and the difference threshold are each a value calculated based on domain knowledge.

5. The data compression device according to any one of claims 1 to 3, further comprising:

   a designated period calculation unit to calculate the designated period based on a duration of each consecutive value included in the time-series data; and
   a difference threshold calculation unit to calculate the difference threshold based on a difference between a value of each consecutive value included in the time-series data and a value of a data point immediately preceding the start point in a time-series manner of said each consecutive value.

6. The data compression device according to claim 5, further comprising:
   a statistic selection unit to select a statistic used when calculating the designated period and a statistic used when calculating the difference threshold.

7. The data compression device according to claim 5 or 6, further comprising:
   a parameter determination unit to determine whether or not to adopt each of the calculated designated period and the calculated difference threshold based on an accuracy of a machine learning model trained using data restored from the compressed data, to an accuracy of a machine learning model trained using the time-series data.

8. A data compression method executed by a data compression device being a computer which compresses discrete time-series data including a plurality of consecutive values consisting of time-series consecutive one or more data points indicating identical values,
   wherein, assuming that each consecutive value included in the time-series data is a target consecutive value, the data compression method comprising, by the data compression device:

determining that the target consecutive value is noise if a duration of the target consecutive value is less than a designated period and a difference between a value of the target consecutive value and a value of a data point immediately preceding a start point in a time-series manner of the target consecutive value is less than or equal to a difference threshold;

determining that the target consecutive value is not noise if the duration of the target consecutive value is equal to or greater than the designated period and the difference between the value of the target consecutive value and the value of the data point immediately preceding the start point in a time-series manner of the target consecutive value is less than or equal to the difference threshold; and

generating compressed data being data that: does not indicate each consecutive value determined to be noise; indicates each consecutive value determined not to be noise; and is obtained by compressing the time-series data.

9. A data compression program executed by a data compression device being a computer which compresses discrete time-series data including a plurality of consecutive values consisting of time-series consecutive one or more data points indicating identical values,

the data compression program, assuming that each consecutive value included in the time-series data is a target consecutive value, causing the data compression device to execute a noise determination process including:

determining that the target consecutive value is noise if a duration of the target consecutive value is less than a designated period and a difference between a value of the target consecutive value and a value of a data point immediately preceding a start point in a time-series manner of the target consecutive value is less than or equal to a difference threshold;

determining that the target consecutive value is not noise if the duration of the target consecutive value is equal to or greater than the designated period and the difference between the value of the target consecutive value and the value of the data point immediately preceding the start point in a time-series manner of the target consecutive value is less than or equal to the difference threshold; and

generating compressed data being data that: does not indicate each consecutive value determined to be noise; indicates each consecutive value determined not to be noise; and is obtained by compressing the time-series data.

## Fig.1

90

18:RESTORED DATA

1:CLOUD SYSTEM

200:DATA RESTORATION DEVICE

RESTORATION UNIT — 17

14

DATABASE — 15

100:DATA COMPRESSION DEVICE

14:COMPRESSED DATA

13:DIFFERENCE THRESHOLD

12:DESIGNATED PERIOD

NOISE DETERMINATION UNIT — 11

10:ENCODED DATA

ENCODING UNIT — 9

5

DATA RECEPTION UNIT — 7

5:TIME-SERIES DATA

6:NETWORK

2-1    2-2    2-3

SENSOR    SENSOR    SENSOR

EP 4 783 465 A1

## Fig.2

18:RESTORED DATA

90

1:CLOUD SYSTEM

200:DATA RESTORATION DEVICE

RESTORATION UNIT — 17

14, 22

DATABASE — 15

14, 22

DATA RECEPTION UNIT — 7

22:RESTORATION METHOD

19-1:EDGE SYSTEM

100:DATA COMPRESSION DEVICE

14:COMPRESSED DATA

13:DIFFERENCE THRESHOLD

NOISE DETERMINATION UNIT — 11

6:NETWORK

12:DESIGNATED PERIOD

10:ENCODED DATA

ENCODING UNIT — 9

19-2

19-3

EDGE SYSTEM

EDGE SYSTEM

5:TIME-SERIES DATA

2-2

2-3

SENSOR — 2-1

SENSOR

SENSOR

# Fig.3

DESIGNATED PERIOD : ≧3、
DIFFERENCE THRESHOLD : >0.5

VALUE

● : ORIGINAL DATA

◍ : SAVED DATA

DIFFERENCE 1.0 > 0.5

S4   S6

S3   S5

PERIOD 0≧3

PERIOD 3≧3   PERIOD 1≧3

D1

DIFFERENCE 0.5≯0.5

SAVE DATA ALTHOUGH PERIOD IS LESS THAN
DESIGNATED PERIOD, BECAUSE DIFFERENCE
IS GREATER THAN DIFFERENCE THRESHOLD

S1   D1'   S2

S1'

t1

TIME

EP 4 783 465 A1

# Fig.4

MAXIMUM FLUCTUATION WIDTH ANTICIPATED FROM PERFORMANCE OF AIR CONDITIONER ALONE

ROOM TEMPERATURE

$\alpha \leq$ DIFFERENCE THRESHOLD

SETTING TEMPERATURE

$z$ MINUTES

$x_i$   $x_{i+z}$   TIME

(a) STEADY STATE AND TRANSIENT STATE

$y$

$y = f(x)$

$|f(x_i) - f(x_{i+1})|$

$x_i$   $x_{i+1}$   $x$

(B) FUNCTION CORRESPONDING TO PERFORMANCE OF AIR CONDITIONER

EP 4 783 465 A1

Fig.5

# Fig.6

DATA COMPRESSION DEVICE

100

| PROCESSOR | MEMORY UNIT | AUXILIARY STORAGE DEVICE |

51    52    53

59

| INPUT/OUTPUT IF | COMMUNICATION DEVICE |

54    55

EP 4 783 465 A1

## Fig.7

START

↓

S101
INPUT TIME-SERIES DATA 5

↓

S102
ENCODE TIME-SERIES DATA 5

↓

S103
INPUT DESIGNATED PERIOD 12

S104
INPUT DIFFERENCE THRESHOLD 13

ENCODED DATA 10
DESIGNATED PERIOD 12
DIFFERENCE THRESHOLD 13

↓

S105
BASED ON DESIGNATED PERIOD 12 AND DIFFERENCE THRESHOLD 13, DETERMINE CONSECUTIVE VALUES, BEING NOISE, FROM ENCODED DATA 10, AND DELETE CONSECUTIVE VALUES DETERMINED AS NOISE

↓ COMPRESSED DATA 14

OUTPUT COMPRESSED DATA 14 S106

↓

END

# Fig.8

```
                              ┌─────────────┐
                              │    START    │
                              └─────────────┘
```

**S121** INPUT ENCODED DATA 10

**S122** INPUT DESIGNATED PERIOD 12

**S123** INPUT DIFFERENCE THRESHOLD 13

**S124**
$P$:=DESIGNATED PERIOD 12, $D$:=DIFFERENCE THRESHOLD 13, ENCODED DATA 10:=$(X, Y)$
$X[k]$:= kTH TIME IN TIME-SERIES DATA 5, $Y[k]$:= VALUE OF kTH ELEMENT IN TIME-SERIES DATA 5,
$n$:=MAXIMUM VALUE OF SUFFIX OF TIME-SERIES DATA 5 $(1 \leq k \leq n)$
$E[k]$:=SUFFIX OF $X$ CORRESPONDING TO kTH ELEMENT IN ENCODED DATA 10 $(0 \leq E[k] \leq n)$

**S125**
$i = 1, E' = \phi$ (OF ENCODED DATA 10, STORE $E$ DETERMINED AS NOISE)

$\text{A}$

# Fig.9

S126 — $i < n$ ?
NO / YES

S127 — $X[E[i+1]-1] - X[E[i]] < \text{P}$ ?
YES / NO

S128 — $\left| Y[E[i+1]-1] - Y[E[i]] \right| \leq \text{D}$ ?
YES / NO

S129 — $E' = E' \cup E[i]$

S130 — $i \mathrel{+}= 1$

S131 — $E'' = E \setminus E'$

S132 — COMPRESSED DATA 14$= (X[E''], Y[E''])$

S133 — OUTPUT COMPRESSED DATA 14

END

# Fig.10

EP 4 783 465 A1

# Fig.11

18:RESTORED DATA

90

1:CLOUD SYSTEM

200:DATA RESTORATION DEVICE

RESTORATION UNIT — 17

35:PAST TIME-SERIES DATA

14

DATABASE — 15

100:DATA COMPRESSION DEVICE

14:COMPRESSED DATA

30   33:STATISTIC

13:DIFFERENCE THRESHOLD

STATISTIC SELECTION UNIT

DIFFERENCE THRESHOLD CALCULATION UNIT

NOISE DETERMINATION UNIT — 11

34

DESIGNATED PERIOD CALCULATION UNIT

32

31:STATISTIC

12:DESIGNATED PERIOD

10:ENCODED DATA

ENCODING UNIT — 9

5

DATA RECEPTION UNIT — 7

5:TIME-SERIES DATA

6:NETWORK

2-1   SENSOR     2-2   SENSOR     2-3   SENSOR

EP 4 783 465 A1

# Fig.12

30

STATISTIC SELECTION UNIT

301

STATISTIC LIST

ARITHMETIC MEAN
MEDIAN
MODE
TRIMMED MEAN
WEIGHTED MEAN
. . .

Fig.13

## Fig.14

START

S101 INPUT TIME-SERIES DATA 5

S201 SELECT STATISTIC 31 AND STATISTIC 33

S102 ENCODE TIME-SERIES DATA 5

S202 INPUT PAST TIME-SERIES DATA 35 AND TIME-SERIES DATA 5

STATISTIC 31
PAST TIME-SERIES DATA 35
TIME-SERIES DATA 5

STATISTIC 33
PAST TIME-SERIES DATA 35
TIME-SERIES DATA 5

S203 CALCULATE DESIGNATED PERIOD 12

S204 CALCULATE DIFFERENCE THRESHOLD 13

DESIGNATED PERIOD 12

DIFFERENCE THRESHOLD 13

ENCODED DATA 10
DESIGNATED PERIOD 12
DIFFERENCE THRESHOLD 13

S105 BASED ON DESIGNATED PERIOD 12 AND DIFFERENCE THRESHOLD 13, DETERMINE CONSECUTIVE VALUES, BEING NOISE, FROM ENCODED DATA 10, AND DELETE CONSECUTIVE VALUES DETERMINED AS NOISE

COMPRESSED DATA 14

S106 OUTPUT COMPRESSED DATA 14

END

# Fig.15

START

EP 4 783 465 A1

S221
INPUT STATISTIC LIST 301

S222
SELECT STATISTIC 31 FROM
STATISTIC LIST 301

S224
SELECT STATISTIC 33 FROM
STATISTIC LIST 301

S223
OUTPUT STATISTIC 31 TO DESIGNATED
PERIOD CALCULATION UNIT 32

S225
OUTPUT STATISTIC 33 TO
DIFFERENCE THRESHOLD CALCULATION UNIT 34

END

## Fig.16

START

INPUT STATISTIC 31 — S241

INPUT TIME-SERIES DATA 5 — S242

INPUT PAST TIME-SERIES DATA 35 — S243

$Seq$ =TIME-SERIES DATA 5 — S244

PAST TIME-SERIES DATA 35 EXISTS? — S245

NO

YES

$Seq$ +=PAST TIME-SERIES DATA 35 — S246

FROM $Seq$, EXTRACT $n$ PIECES OF CONSECUTIVE VALUES AS $period[i](1 \leq i \leq n)$ — S247

CALCULATION OF DESIGNATED PERIOD 12 — S248

OUTPUT OF DESIGNATED PERIOD 12 — S249

END

EP 4 783 465 A1

# Fig.17

```
                          START
```

S261 — INPUT STATISTIC 33

S262 — INPUT TIME-SERIES DATA 5

S263 — INPUT PAST TIME-SERIES DATA 35

S264 — $Seq$=TIME-SERIES DATA 5

S265 — PAST TIME-SERIES DATA 35 EXISTS? — NO

YES

S266 — $Seq$ +=PAST TIME-SERIES DATA 35

S267 — FROM $Seq$, EXTRACT $m$ PIECES OF DATA POINT DIFFERENCES AS $diff[i](1 \leq i \leq m)$

S268 — CALCULATION OF DIFFERENCE THRESHOLD 13

S269 — OUTPUT OF DIFFERENCE THRESHOLD 13

```
                           END
```

## Fig.18

EP 4 783 465 A1

## Fig.19

EP 4 783 465 A1

40:PARAMETER DETERMINATION UNIT

41:RESTORED DATA

35:PAST
TIME-SERIES DATA
5:TIME-SERIES DATA

401
MODEL
GENERATION
UNIT

403:DETERMINATION
TARGET MODEL

404
INFERENCE UNIT

406:INFERENCE RESULT

407
ACCURACY
DETERMINATION
UNIT

43:
ADOPT/NOT-ADOPT

402:COMPARISON MODEL

405:INFERENCE RESULT

## Fig.20

STATISTIC SELECTION UNIT  ～30

STATISTIC LIST  ～301

ARITHMETIC MEAN
MEDIAN
MODE
TRIMMED MEAN
WEIGHTED MEAN
・ ・ ・

USED TABLE  ～302

| NUMBER | DESIGNATED PERIOD | DIFFERENCE THRESHOLD |
|---|---|---|
| 1 | ARITHMETIC MEAN | ARITHMETIC MEAN |
| 2 | ARITHMETIC MEAN | MEDIAN |
| 3 | MEDIAN | MODE |

# Fig.21

CALCULATION OF DESIGNATED PERIOD

CALCULATION OF DIFFERENCE THRESHOLD

STATISTIC LIST — 301

ARITHMETIC MEAN
MEDIAN
MODE
TRIMMED MEAN
WEIGHTED MEAN
· · ·

TIME-SERIES DATA(RAW DATA)

FEATURE EXTRACTION

FEATURE DATA

RESTORATION

RESTORED DATA

TRAIN

TRAIN

PARAMETER DETERMINATION

MACHINE LEARNING MODEL

INFERENCE

ACCURACY TEST

NOT ADOPT

## Fig.22

```
                    ┌─────────┐
                    │  START  │
                    └─────────┘
                         │
                         ▼
                      ◇─────────────────────────────────────┐
                     ╱ ╲                                     │
        ┌────────────┘   └────────────┐                      │
        ▼                             ▼                      │
  S101                         S201                          │
 ╱INPUT TIME-SERIES DATA 5╱    ║SELECT STATISTIC 31 AND STATISTIC 33║
        │                             │                      │
        ▼                    S202     ▼                      │
  S102                      ╱INPUT PAST TIME-SERIES DATA 35 AND TIME-SERIES DATA 5╱
 ║ENCODE TIME-SERIES DATA 5║                                 │
        │                   STATISTIC 31          STATISTIC 33
        │                   PAST TIME-SERIES       PAST TIME-SERIES DATA 35
        │                   DATA 35                TIME-SERIES DATA 5
        │                   TIME-SERIES DATA 5
        │           S203         ▼          S204     ▼
        │     ┌CALCULATE DESIGNATED PERIOD 12┐  ┌CALCULATE DIFFERENCE THRESHOLD 13┐
        │     └──────────────────────────────┘  └────────────────────────────────┘
        │       DESIGNATED PERIOD 12              DIFFERENCE THRESHOLD 13
        │                                         ENCODED DATA 10
        │                                         DESIGNATED PERIOD 12
        │                                         DIFFERENCE THRESHOLD 13
        │                         ▼                              S105
 ┌──────────────────────────────────────────────────────────────────┐
 ║ BASED ON DESIGNATED PERIOD 12 AND DIFFERENCE THRESHOLD 13,         ║
 ║ DETERMINE CONSECUTIVE VALUES, BEING NOISE, FROM ENCODED DATA 10,   ║
 ║ AND DELETE CONSECUTIVE VALUES DETERMINED AS NOISE                  ║
 └──────────────────────────────────────────────────────────────────┘
                         │
                         ▼
                       ( B )                                ( C )
```

EP 4 783 465 A1

# Fig.23

EP 4 783 465 A1

## Fig.24

```
                              ┌─────────────┐
                              │    START    │
                              └──────┬──────┘
        S221                         │                          S321
  ┌────────────────────────┐   ┌─────────────────────────────────────┐
 /  INPUT STATISTIC LIST 301/   /      INPUT USED TABLE 302          /
  └────────────────────────┘   └─────────────────────────────────────┘
                                 STATISTIC LIST 301
                                 USED TABLE 302
                                      ◇
        S222                                              S224
  ┌────────────────────────┐   ┌─────────────────────────────────┐
  │  SELECT STATISTIC 31 FROM │  │  SELECT STATISTIC 33           │
  │  STATISTIC LIST 301      │  │  FROM STATISTIC LIST 301        │
  └────────────────────────┘   └─────────────────────────────────┘
     STATISTIC 31                         STATISTIC 33
                                                          S322
  ┌──────────────────────────────────────────────────────────┐  YES
  │  STATISTIC 31 AND STATISTIC 33 EXIST IN USED TABLE 302?   │
  └──────────────────────────────────────────────────────────┘
                          NO
                                                          S323
  ┌──────────────────────────────────────────────────────────┐
  │  RECORD STATISTIC 31 AND STATISTIC 33 TO USED TABLE 302   │
  └──────────────────────────────────────────────────────────┘
     S223                              S225
  ┌────────────────────────┐   ┌─────────────────────────────────┐
 /  OUTPUT STATISTIC 31 TO  /   /  OUTPUT STATISTIC 33 TO DIFFERENCE/
 / DESIGNATED PERIOD        /   / THRESHOLD CALCULATION UNIT 34    /
 / CALCULATION UNIT 32     /   └─────────────────────────────────┘
  └────────────────────────┘
                              ┌─────────────┐
                              │    END      │
                              └─────────────┘
```

EP 4 783 465 A1

## Fig.25

```
                          START

    S341                          S342              S343
INPUT TIME-SERIES DATA 5    INPUT PAST          INPUT RESTORED DATA 41
                            TIME-SERIES DATA 35

                    BaseSeq = TIME-SERIES DATA 5        S344

                                                        S345
                    PAST TIME-SERIES DATA 35 EXISTS?    NO

                          YES
                    BaseSeq += PAST TIME-SERIES DATA 35    S346

    S347                                          S350
SPLIT INTO TRAIN DATA AND TEST DATA         SPLIT INTO TRAIN DATA AND TEST DATA
TrainDate, TestData = Split(BaseSeq)        TrainDate, TestData = Split(RESTORED DATA 41)

            D                                       E
```

# Fig.26

(D)

TAKE *TrainData* AS INPUT AND
GENERATE COMPARISON MODEL 402 — S348

COMPARISON MODEL 402

INPUT *TestData* TO COMPARISON MODEL 402
AND OUTPUT INFERENCE RESULT 405 — S349

INFERENCE RESULT 405

(E)

TAKE *TrainData* AS INPUT AND
GENERATE DETERMINATION TARGET MODEL 403 — S351

DETERMINATION
TARGET MODEL 403

INPUT *TestData* TO DETERMINATION TARGET MODEL 403
AND OUTPUT INFERENCE RESULT 406 — S352

INFERENCE RESULT 406

CALCULATE ERROR OF INFERENCE RESULT 406 AGAINST INFERENCE RESULT 405
BASED ON PREDETERMINED INDEX — S353

ERROR

ERROR GREATER THAN OR EQUAL
TO TRESHOLD? — S354

YES — ADOPT/NOT-ADOPT 43=NOT ADOPT — S355

NO — ADOPT/NOT-ADOPT 43=ADOPT — S356

ADOPT/NOT-ADOPT 43

OUTPUT OF ADOPT/NOT-ADOPT 43 — S357

END

## INTERNATIONAL SEARCH REPORT

| International application No. |
| --- |
| **PCT/JP2023/039338** |

| | |
| --- | --- |
| **A. CLASSIFICATION OF SUBJECT MATTER** | |

*H03M 7/30*(2006.01)i; *H03M 7/46*(2006.01)i
FI:  H03M7/30 Z; H03M7/46

According to International Patent Classification (IPC) or to both national classification and IPC

**B. FIELDS SEARCHED**

Minimum documentation searched (classification system followed by classification symbols)

H03M7/30; H03M7/46

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

IEEE Xplore

**C. DOCUMENTS CONSIDERED TO BE RELEVANT**

| Category* | Citation of document, with indication, where appropriate, of the relevant passages | Relevant to claim No. |
| --- | --- | --- |
| A | JP 2007-104271 A (FUJI XEROX CO., LTD.) 19 April 2007 (2007-04-19) paragraphs [0042]-[0059], fig. 6-8 | 1-9 |
| A | JP 03-55919 A (DAICEL CHEM. IND. LTD.) 11 March 1991 (1991-03-11) p. 2, lower right column, line 15 to p. 4, lower left column, line 7, fig. 2-3 | 1-9 |

☐ Further documents are listed in the continuation of Box C.   ☑ See patent family annex.

| | | |
| --- | --- | --- |
| * Special categories of cited documents: | "T" | later document published after the international filing date or priority date and not in conflict with the application but cited to understand the principle or theory underlying the invention |
| "A" document defining the general state of the art which is not considered to be of particular relevance | | |
| "E" earlier application or patent but published on or after the international filing date | "X" | document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" document referring to an oral disclosure, use, exhibition or other means | | |
| "P" document published prior to the international filing date but later than the priority date claimed | "&" | document member of the same patent family |

| Date of the actual completion of the international search | Date of mailing of the international search report |
| --- | --- |
| **13 December 2023** | **26 December 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/039338**

| Patent document cited in search report | | | Publication date (day/month/year) | Patent family member(s) | Publication date (day/month/year) |
|---|---|---|---|---|---|
| JP | 2007-104271 | A | 19 April 2007 | (Family: none) | |
| JP | 03-55919 | A | 11 March 1991 | (Family: none) | |

Form PCT/ISA/210 (patent family annex) (January 2015)

**EP 4 783 465 A1**

**Patent documents cited in the description**

- JP 2001165712 A